(19) Europäisches Patentamt
European Patent Office
Office européen des brevets

(11) EP 4 343 454 A1

(12) EUROPEAN PATENT APPLICATION

(43) Date of publication:
**27.03.2024 Bulletin 2024/13**

(21) Application number: **22197069.2**

(22) Date of filing: **22.09.2022**

(51) International Patent Classification (IPC):
***G04F 10/00*** *(2006.01)* *H03L 7/08* *(2006.01)*
*H03L 7/087* *(2006.01)*

(52) Cooperative Patent Classification (CPC):
**G04F 10/005;** H03L 7/087

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**KH MA MD TN**

(71) Applicant: **INTEL Corporation**
**Santa Clara, CA 95054 (US)**

(72) Inventors:
- **DEGANI, Ofir**
**22801 Nes-Ammin (IL)**
- **SHUMAKER, Evgeny**
**3680304 Nesher (IL)**

(74) Representative: **Viering, Jentschura & Partner mbB**
**Patent- und Rechtsanwälte**
**Am Brauhaus 8**
**01099 Dresden (DE)**

# (54) TIME-TO-DIGITAL CONVERTERS, DIGITAL-PHASE-LOCKED LOOPS AND METHODS FOR OPERATING TIME-TO-DIGITAL CONVERTERS

(57) A time-to-digital converter may include a delay circuit configured to delay a first signal to generate a plurality of delayed first signals; a circuit configured to generate a first analog oscillating signal and a second analog oscillating signal using an input second signal, wherein the second analog oscillating signal is phase offset with respect to the first analog oscillating signal; a first plurality of sample circuits, each configured to sample the first analog oscillating signal in accordance with an associated delayed first signal of the delayed first signals, and a second plurality of sample circuits, each configured to sample the second analog oscillating signal in accordance with an associated delayed first signal of the delayed first signals. Each of the delayed first signals is provided to a respective sample circuit of the first plurality of sample circuits and to a respective sample circuit of the second plurality of sample circuits.

FIG 5

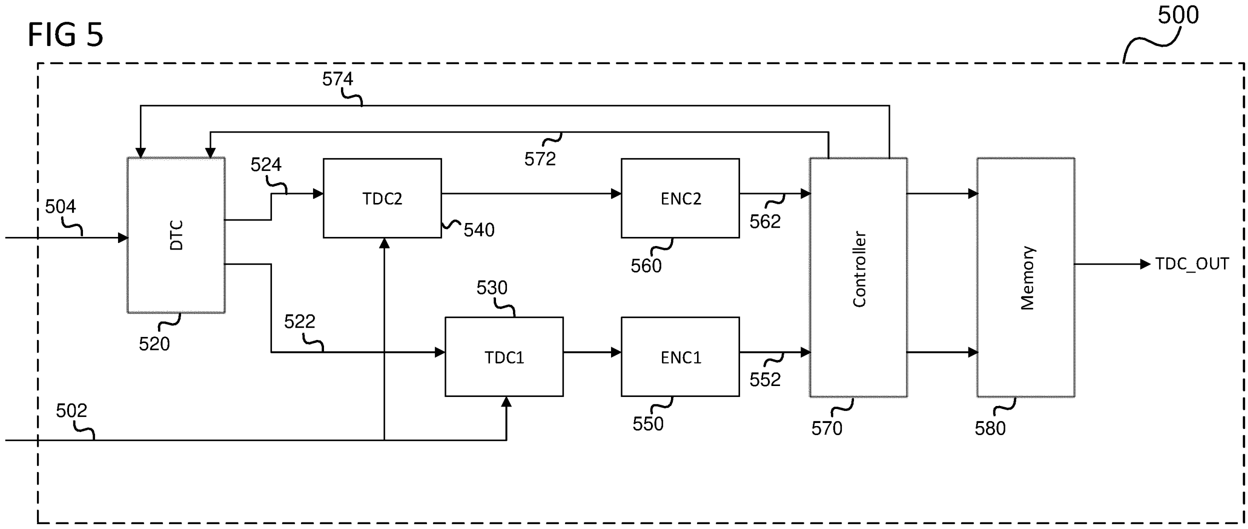




Processed by Luminess, 75001 PARIS (FR)

## Description

### Technical Field

Various aspects of this disclosure generally relate to time-to-digital conversion. By way of example, various aspects relate to time-to-digital converters, digital phase-locked loops and methods for operating time-to-digital converters.

### Background

A digital phase-locked loop, DPLL, provides a low power and small area alternative to analog phase-locked loops. In a DPLL, the phase offset between two signals, typically between a local oscillator signal and a reference clock signal, is quantified by a time-to-digital converter, TDC.

An example of a TDC is a flash-TDC including a delay line and numerous sampling elements latching at different points in time. A flash-TDC provides a high resolution phase quantization. This comes, however, at the considerable expense of a high number of circuits operating within a small time segment. The high device count in a flash-TDC also elevates the power consumption and affects other surrounding components, causing for example strong periodic modulations of the output signal. Furthermore, without reducing the device count it may be diffcult to increase the quantiziation bandwith of the TDC.

An alternative to a flash-TDC is a TDC where the number of sampling elements are reduced to the minimum. However, such a TDC requires the prediction of the location of an edge of the sampled signal. Because it is almost impossible to predict said location of an edge with sufficient precison, the quantization quality may suffer as a result.

### Brief Description of the Drawings

In the drawings, like reference characters generally refer to the same parts throughout the different views. The drawings are not necessarily to scale, emphasis instead generally being placed upon illustrating the principles of the invention. It should be understood that the drawings are diagrammatic and schematic representations of exemplary aspects of the invention, and are neither limitative nor necessarily drawn to scale of the present invention. In the following description, various embodiments of the invention are described with reference to the following drawings, in which:

FIG. 1 shows an exemplary TDC;
FIG.2 shows another exemplary TDC;
FIG. 3 shows an exemplary TDC including a DTC according to some aspects;
FIG. 4 shows an example of a time period divided into overlapping time segments;
FIG 5 shows an exemplary TDC according to some aspects;
FIG 6 shows an example of the contents of a lookup table at the end of a successful calibration method;
FIG. 7 shows an exemplary flow diagram for calculating the next expected phase output;
FIG 8 shows an example of a DPLL including a TDC according to some aspects;
FIG. 9 shows a TDC according to some aspects;
FIG. 10 shows a flowchart illustrating a method for operating a TDC according to some aspects;
FIG. 11 shows a flowchart illustrating a method for operating a TDC according to some aspects; and
FIG. 12 shows a flowchart illustrating a method for operating a TDC according to some aspects;

### Description

The following detailed description refers to the accompanying drawings that show, by way of illustration, specific details and embodiments in which the invention may be practiced.

The word "exemplary" is used herein to mean "serving as an example, instance, or illustration". Any embodiment or design described herein as "exemplary" is not necessarily to be construed as preferred or advantageous over other embodiments or designs.

The terms "at least one" and "one or more" may be understood to include a numerical quantity greater than or equal to one (e.g., one, two, three, four, [...], etc.). The term "a plurality" may be understood to include a numerical quantity greater than or equal to two (e.g., two, three, four, five, [...], etc.).

The words "plural" and "multiple" in the description and in the claims expressly refer to a quantity greater than one. Accordingly, any phrases explicitly invoking the aforementioned words (e.g., "plural [elements]", "multiple [elements]") referring to a quantity of elements expressly refers to more than one of the said elements. The phrases "group (of)", "set (of)", "collection (of)", "series (of)", "sequence (of)", "grouping (of)", etc., and the like in the description and in the claims, if any, refer to a quantity equal to or greater than one, i.e., one or more. The phrases "proper subset", "reduced subset", and "lesser subset" refer to a subset of a set that is not equal to the set, illustratively, referring to a subset of a set that contains less elements than the set.

The phrase "at least one of' with regard to a group of elements may be used herein to mean at least one element from the group including the elements. For example, the phrase "at least one of' with regard to a group of elements may be used herein to mean a selection of: one of the listed elements, a plurality of one of the listed elements, a plurality of individual listed elements, or a plurality of a multiple of individual listed elements.

The term "data" as used herein may be understood to include information in any suitable analog or digital form, e.g., provided as a file, a portion of a file, a set of files, a signal or stream, a portion of a signal or stream, a set of signals or streams, and the like. Further, the term "data" may also be used to mean a reference to information, e.g., in form of a pointer. The term "data", however, is not limited to the aforementioned examples and may take various forms and represent any information as understood in the art.

The terms "processor" or "controller" as, for example, used herein may be understood as any kind of technological entity that allows handling of data. The data may be handled according to one or more specific functions executed by the processor or controller. Further, a processor or controller as used herein may be understood as any kind of circuit, e.g., any kind of analog or digital circuit, and may also be referred to as a "processing circuit," "processing circuitry," among others. A processor or a controller may thus be or include an analog circuit, digital circuit, mixed-signal circuit, logic circuit, processor, microprocessor, Central Processing Unit (CPU), Graphics Processing Unit (GPU), Digital Signal Processor (DSP), Field Programmable Gate Array (FPGA), integrated circuit, Application Specific Integrated Circuit (ASIC), etc., or any combination thereof. Any other kind of implementation of the respective functions, which will be described below in further detail, may also be understood as a processor, controller, or logic circuit. It is understood that any two (or more) of the processors, controllers, or logic circuits detailed herein may be realized as a single entity with equivalent functionality, among others , and conversely that any single processor, controller, or logic circuit detailed herein may be realized as two (or more) separate entities with equivalent functionality, among others.

As used herein, "memory" is understood as a computer-readable medium in which data or information can be stored for retrieval. References to "memory" included herein may thus be understood as referring to volatile or non-volatile memory, including random access memory (RAM), read-only memory (ROM), flash memory, solid-state storage, magnetic tape, hard disk drive, optical drive, among others, or any combination thereof. Registers, shift registers, processor registers, data buffers, among others, are also embraced herein by the term memory. The term "software" refers to any type of executable instruction, including firmware.

Unless explicitly specified, the term "transmit" encompasses both direct (point-to-point) and indirect transmission (via one or more intermediary points). Similarly, the term "receive" encompasses both direct and indirect reception. Furthermore, the terms "transmit," "receive," "communicate," and other similar terms encompass both physical transmission (e.g., the transmission of radio signals) and logical transmission (e.g., the transmission of digital data over a logical software-level connection). For example, a processor or controller may transmit or receive data over a software-level connection with another processor or controller in the form of radio signals, where the physical transmission and reception is handled by radio-layer components such as RF transceivers and antennas, and the logical transmission and reception over the software-level connection is performed by the processors or controllers. The term "communicate" encompasses one or both of transmitting and receiving, i.e., unidirectional or bidirectional communication in one or both of the incoming and outgoing directions. The term "calculate" encompasses both 'direct' calculations via a mathematical expression/formula/relationship and 'indirect' calculations via lookup or hash tables and other array indexing or searching operations.

**FIG. 1** illustrates an exemplary Time-to-Digital converter, TDC, 100. The TDC 100 may include a delay circuit 110 (not shown) configured to iteratively delay a first signal 102, for example a reference signal or an oscillation signal (e.g. a local oscillator signal), to generate a plurality of delayed first signals 102-1, 102-2, ..., 102-n. The delay circuit 110 includes a plurality of delay elements (e.g. delay structures or delay circuits) 106, wherein each delay element 106 is configured to (iteratively) delay the first signal 102 by a predefined amount of time. Each of the delay elements 106 is accordingly configured to output a respective delayed first signal. The TDC 100 may further include a plurality of sampling circuits 108-1, 108-2, ..., 108-n, each configured to sample a (received) second signal 104, for example an oscillation signal or a reference signal, based on one of the plurality of delayed first signals 102-1, 102-2, ..., 102-n.

All delay elements 106 may delay the first signal 102 or a delayed first signal by a same delay time, respectively.

The plurality of sampling circuits 108-1, 108-2, ..., 108-n may sample the second signal 104 at different sample times. The sample time of a respective sampling circuit is (substantially) determined by the respective delayed first signal supplied to it. The plurality of sampling circuits 108-1, 108-2, ..., 108-n may indicate a phase difference between the first signal 102 and the second signal 104. For example, output signals of the plurality of sampling circuits 108-1, 108-2, ..., 108-n may indicate if the second signal 104 is leading or trailing the delayed first signals 102-1, 102-2, ..., 102-n, respectively.

At least one of the plurality of sampling circuits 108-1, 108-2, ..., 108-n may include a plurality of flip-flop circuits, e.g. a plurality of D flip-flop circuits, e.g. edge-triggered D-flip-flop circuits (not illustrated). The plurality of flip-flop circuits 108-1, 108-2, ..., 108-n may be configured to receive the second signal 104 and the delayed first signals 102-1, 102-2, ..., 102-n provided to the respective sampling circuit 108-1, 108-2, .., 108-n.

TDC 100 may be a flash-TDC including a plurality of sampling circuits 108-1, 108-2, ..., 108-n, Each sampling circuit may include exactly one flip-flop circuit. In an alternative, each sampling circuit of TDC 100 may include a plurality of flip-flop circuits (not illustrated), in which case TDC 100 is a stochastic flash TDC.

**FIG. 2** illustrates another exemplary TDC 200. The TDC 200 may include a delay circuit 210 (not shown) configured to iteratively delay a first signal 202, for example a reference signal or an oscillation signal, to generate a plurality of delayed first signals 202-1, 202-2, ..., 202-n. The delay circuit 210 may include a plurality of delay elements 206. Each delay element 206 is configured to (iteratively) delay the first signal 202 by a predefined amount of time. Each of the delay elements 206 is accordingly configured to output a respective delayed first signal. The TDC 200 may further include a multiplexer 212 configured to select (at least) one of the delayed first signals out of the plurality of delayed first signals 202-1, 202-2, ..., 202-n and to output the selection to a sampling circuit 208. The sampling circuit 208 is configured to sample a (received) second signal 204, for example a reference signal or an oscillation signal, based on the received output from multiplexer 212, in other words based on the selection of the (at least) one delayed first signals out of the plurality of delayed first signals 202-1, 202-2, ..., 202-n. The circuit 220 including multiplexer 212 and delay circuit 210 may be a Digital-to-Time converter, DTC, 220.

All delay elements 206 may delay the first signal 202 or a delayed first signal by a same delay time, respectively.

Possible improvements of a TDC such as e.g. TDC 100 or TDC 200 include improving the measurement precision (while maintaining the required dynamic range) of the TDC, i.e. reducing its quantization error and increasing the quantization rate (resolution), i.e. increase the rate at which the quantization samples are produced (quantization bandwith).

In order to increase both the measurement precision and the quantization rate of a (flash-)TDC such as e.g TDC 100 it is necessary to increase its device count, for example by increasing the number of sampling circuits 108-1, 108-2, ..., 108-n. Increasing the number of sampling circuits allows to improve the measurement precision, however this comes at the expense of the TDC including a large number of circuits operating within a small time segment. It should further be noted that increasing the number of circuits of the TDC will increase its power consumption and therefore increase its (electrical) effect on surrounding components, such as e.g. the other components in a Digital Phase-Locked Loop, DPLL. A high device count in a TDC may for example cause strong periodic modulations of its output signal and/or of an output signal of a DPLL. Generally speaking, the quantization quality, i.e. the quantization noise contribution, of a TDC may be a limiting factor in the spectral purity of the output of a DPLL.

In a TDC such as e.g. TDC 100, processing is done after the actual sampling instance. Another possible design for a TDC may be provided by single arbiter(s) solutions (or including a small number of sampling circuits) such as e.g. TDC 200. These types of TDCs may also be referred to as DTC assisted TDCs. In TDC 200, the processing may (partially) be done beforehand, allowing for a higher conversion rate, e.g. by using a higher frequency first (reference) signal.

In TDC 200 the number of sampling circuits 208 is reduced to a minimum. In order for TDC 200 to have a high (sufficient) quantization quality, multiplexer 212 has to select a signal out of the plurality of delayed first signals 202-1, 202-2, ..., 202-n (e.g. delayed reference clock signals) having a sampling edge as close as possible to the actual location of the edge of the second signal (e.g. a local oscialltor signal). This implies that the location of the edge of the second signal has to be determined prior to the actual sampling of said second signal. However, predicting the location of the edge of the second signal with sufficient precision is close to impossible due to the limitations (in the resolution) of circuit (DTC) 220. The average quantization quality of a TDC such as e.g. TDC 200 may therefore suffer, leaving at best marginal quantization gains in terms of energy spent per quantization bit.

Thus, a (flash-)TDC such as e.g. TDC 100 may have a high power consumption and may negatively affect surrounding components, and a TDC such as e.g. TDC 200 may not be able to provide a sufficient and/or required resolution (and eventually the required quantization noise).

**FIG. 3** illustrates an exemplary TDC 300 including a DTC 320 according to some aspects. The TDC 300 may include a delay circuit 310 (not shown) configured to iteratively delay a first signal 302, for example a reference signal or an oscillation signal (e.g. a local oscillator signal), to generate a plurality of delayed first signals 302-1, 302-2, ..., 302-n). The delay circuit 310 includes a plurality of delay elements (e.g. delay structures or delay circuits) 306, wherein each delay element 306 is configured to (iteratively) delay the first signal 302 by a predefined amount of time. Each of the delay elements (e.g. delay structures or delay circuits) 306 is accordingly configured to output a respective delayed first signal. The TDC 300 includes a DTC 320 configured to receive a second signal 304, for example a reference signal or an oscillation signal (e.g. a local oscillator signal), and to generate (output) a first output signal 322 and a second output signal 324. The first and second signals output by the DTC 320 may e.g be analog oscillating signals and/or periodic signals. Further, the first output signal 322 is phase offset with respect to the second output signal 324.

It should be noted that while often the first signal 302 is a local oscillator signal and the second signal 304 a reference (clock) signal, it may be provided, in case a high rate version of the local oscillator signal is available at the oscillator output, to use the local oscialltor signal as the second signal 304 (and the reference signal as the first signal 302).

The TDC 300 further includes a first plurality of sampling circuits 312-1, 312-2, ..., 312-n, each configured to sample the (received) first output signal 322 based on one of the plurality of delayed first signals 302-1, 302-2, ..., 102-n, resulting in a series of first sampled signals 322-1, 322-2, ..., 322-n, and a second plurality of sampling circuits 314-1, 314-2, ..., 314-n, each configured to sample a (received) second output signal 324 based on one of the plurality of delayed first signals 302-1, 302-2, ..., 102-n, resulting in a series of second sampled signals 324-1, 324-2, ..., 324-n.

The first plurality of sampling circuits 312-1, 312-2, ..., 312-n may sample the first ouput signal 322 at different sample times and the second plurality of sampling circuits 314-1, 314-2, ..., 314-n may sample the second output signal 324 at different sample times. The sample time of a respective sampling circuit is (substantially) determined by the respective delayed first signal supplied to it. The first plurality of sampling circuits 312-1, 312-2, ..., 312-n may indicate a phase difference between the first signal 302 and the first output signal 322 and/or the second signal 304, and the second plurality of sampling circuits 314-1, 314-2, ..., 314-n may indicate a phase difference between the first signal 302 and the second output signal 324 and/or the second signal 304. For example, output signals of the first plurality of sampling circuits 312-1, 312-2, ..., 312-n may indicate if the first output signal 322 and/or the second signal 304 is leading or trailing the delayed first signals 302-1, 302-2, ..., 302-n, respectively, and output signals of the second plurality of sampling circuits 314-1, 314-2, ..., 314-n may indicate if the second output signal 324 and/or the second signal 304 is leading or trailing the delayed first signals 302-1, 302-2, ..., 302-n, respectively.

At least one of the first and second plurality of sampling circuits 312-1, 312-2, ..., 312-n and 314-1, 314-2, ..., 314-n may include a plurality of flip-flop circuits, e.g. a plurality of D flip-flop circuits, e.g. edge-triggered D-flip-flop circuits (not illustrated). A first plurality of flip-flop circuits 312-1, 312-2, ..., 312-n may be configured to receive the first output signal 322 and the delayed first signals 302-1, 302-2, ..., 302-n provided to the respective sampling circuit 312-1, 312-2, ..., 312-n. A second plurality of flip-flop circuits 314-1, 314-2, ..., 314-n may be configured to receive the second output signal 324 and the delayed first signals 302-1, 302-2, ..., 302-n provided to the respective sampling circuit 314-1, 314-2, ..., 314-n.

TDC 300 may include two (flash-)TDCs 330 and 340, wherein TDC 330 includes the first plurality of sampling circuits 312-1, 312-2, ..., 312-n and TDC 340 includes the second plurality of sampling circuits 314-1, 314-2, ..., 314-n, each sampling circuit including a plurality of flip-flop circuits (not illustrated).

All delay elements 306 may delay the first signal 302 or a delayed first signal by a same delay time, respectively.

The DTC 320 may be a delay line or may be a more complex phase interpolation scheme, depending on the availabity of a higher rate version of the second signal 304.

The series of first sampled signal 322-1, 322-2, ..., 322-n may be assigned to a first time segment of a time period making up the dynamic range of the TDC 300, and the series of second smapled signals 324-1, 324-2, ..., 324-n may be assigned to a second time segment of a time period making up the dynamic range of the TDC 300. The first and second time segments may be small and partially overlapping time segments. The first and second time segments may be roughly centered at the expected location of an edge of the second signal 304.

This approach allows to significantly increase the number of sampling elements of a TDC such as e.g. TDC 300 sampling at a higher rate, while preserving the excellent resolution provided by a post-sampling detection approach.

The first and second time segments may span only a small portion of the total (required) dynamic range of TDC 300. The rest of the dynamic range may be obtained by providing a correspondingly delayed second signal 304 to each of the first plurality and second plurality of sampling circuits in such a way that each of the assigned first time segments and second time segments partially overlap.

**FIG. 4** illustrates an example of a time period divided in overlapping first and second time segments (sampling segments). Time period 410 includes each of the assigned first time segments 402-1, 402-2, ..., 402-n (which may be realized by the TDC 330 consisting of or including the first plurality of sampling circuits 312-1, 312-2, ..., 312-n; to reach each of the 402-1, 402-2, ..., 402-n a different setting of the 320 would be applied to delay 304 into 322) and each of the assigned second time segments 404-1, 404-2, ..., 404-n (which may be realized by the TDC 340 consisting of or including the first plurality of sampling circuits 314-1, 314-2, ..., 314-n; to reach each of the 404-1, 404-2, ..., 404-n a different setting of the 320 would be be applied to delay 304 into 324). This way, the time period 410 may span over the entire availed dynamic range of a TDC such as e.g. TDC 300.

It is to be noted that there is a wide range of possible sampling time lengths, which may depend on various factors, some of which are process factors (e.g. nanometerscale CMOS (Complementary Metal Oxide Semiconductor)) related while other factors may be dependent on the application. In an example of this disclosure, the sampling time length is 32 picosecond, while the signal period is about 200 psec (5 GHz). This means that having some modest (~10-15%) overlap, about 8 sampling segments (different DTC settings) would be provided. Each TDC segment may consist of or include about 8 to 10 effective delay elements, each feeding about 8 flip-flops (this is a stochastic flash TDC setup).

The length of each time segment, $T_{smpl}$, may e.g. (approximately) be 32 psec, however, other values for $T_{smpl}$

may be provided. The distance between the beginnings of two adjacent time segments, $T_{delay}$, may e.g. (approximately) be 28 psec, however, other values for $T_{delay}$ may be provided. The overlap between two adjacent time segments may therefore (approximately) be 4 psec. An overlap between two adjacent time segments is necessary in order to ensure a contiguous dynamic range, i.e. to ensure covering the entire dynamic range of the TDC. It is to be noted that the numbes above are only an example and can vary over a wide range depending also on a concrete application.

**FIG. 5** illustrates an exemplary TDC 500 according to some aspects. The TDC 500 may include a delay circuit 510 (not shown) configured to iteratively delay a first signal 502, for example a reference signal or an oscillation signal (e.g. a local oscillator signal), to generate a plurality of delayed first signals 502 1, 502-2, ..., 502-n. The delay circuit 510 includes a plurality of delay elements (e.g. delay structures or delay circuits) 506 (not shown), wherein each delay element 506 is configured to (iteratively) delay the first signal 502 by a predefined amount of time. Each of the delay elements 506 is accordingly configured to output a respective delayed first signal. All delay elements 506 may delay the first signal 502 or a delayed first signal by a same delay time, respectively. The TDC 500 includes a DTC 520 configured to receive a second signal 504, for example an oscillation signal or a reference signal, and to generate (output) a first output signal 522 and a second output signal 524. The first and second signals output by DTC 520 may e.g be analog oscillating signals and/or periodic signals. Further, the first output signal 522 is phase offset with respect to the second output signal 524.

TDC 500 further includes a first TDC 530 and a second TDC 540. The first TDC 530 includes a first plurality of sampling circuits 532-1, 532-2, ..., 532-n, (not shown), each configured to sample the (received) first output signal 522 on the basis of one of the plurality of delayed first signals 502-1, 502-2, ..., 502-n. The second TDC 540 includes a second plurality of sampling circuits 542-1, 542-2, ..., 542-n, (not shown), each configured to sample the (received) second output signal 524 on the basis of one of the plurality of delayed first signals 502-1, 502-2, ..., 502-n.

At least one of the first plurality of sampling circuits 532-1, 532-2, ..., 532-n of TDC 530 and of the second plurality of sampling circuits 542-1, 542-2, ..., 542-n of TDC 540 may include a plurality of flip-flop circuits, e.g. a plurality of D flip-flop circuits, e.g. edge-triggered D-flip-flop circuits (not illustrated). A first plurality of flip-flop circuits 532-1, 532-2, ..., 532-n may be configured to receive the first output signal 522 and the delayed first signals 502-1, 502-2, ..., 502-n provided to the respective sampling circuit 532-1, 532-2, ..., 532-n. A second plurality of flip-flop circuits 542-1, 542-2, ..., 542-n may be configured to receive the second output signal 524 and the delayed first signals 502-1, 502-2, ..., 502-n provided to the respective sampling circuit 542-1, 542-2, ..., 542-n.

TDCs 530 and 540 may be flash-TDCs, with TDC 530 including the first plurality of sampling circuits 532-1, 532-2, ..., 532-n and TDC 540 including the second plurality of sampling circuits 542-1, 542-2, ..., 542-n, each sampling circuit including a plurality of flip-flop circuits (not illustrated).

TDC 530 inputs a series of first sampled signals 522-1, 522-2, ..., 522-n, each corresponding to an assigned first time segment 402-1, 402-2, ..., 402-n, respectively. TDC 540 inputs a series of second sampled signals 524-1, 524-2, ..., 524-n, each corresponding to an assigned second time segment 404-1, 404-2, ..., 404-n, respectively. In other words: in one sampling iteration (in case we sample once each reference clock cycle, for example), each TDC (530 and 540) gets one of the first output signal 522 or the second output signal 524 which realizes one of first or second time segments 402, 404.

As indicated in FIG. 5, the output of the first TDC 530 is encoded by a first encoder 550, and the output of the second TDC 540 is encoded by a second encoder 560.

In a basic mode of operation of TDC 500 only one type of edge (rising or falling) of the delayed second signals 504 is quantized. In this mode, the first encoder 550 outputs first offset information 552 indicative of whether or not an edge has been found in the respective (corresponding) first time segment 402, and the second encoder 560 outputs second offset information 562 indicative of whether or not an edge has been found in the respective (corresponding) second time segment 404. The time segments may further be chosen in such a way that at most one edge is registered (found) in a single time segment.

TDC 500 may further be configured to output a value $TDC_{OUT}$ indicative of the phase difference between the first signal 502 and the second signal 504.

**FIG. 6** shows an exemplary flow diagram for calculating the next expected phase output by a TDC such as e.g. TDC 300 illustrated in FIG. 3 or TDC 500 illustrated in FIG. 5. In the exemplary method 600 of FIG. 6, the first signal is a reference clock, REF, signal and the second signal is a local oscillator, LO, signal. The method 600 of FIG. 6 may in particular be used in a basic mode of operation of TDC 500. In various aspects of this disclosure, LO signal 504 is quantized at moments of the edges of the REF signal 502.

Let $f_{LO}$ denote the LO frequency estimate (usually normalized to REF clock frequency) and $P_{eff}$ denote the LO cycle length estimate in terms of TDC (time segments) units. The fractional frequency advancement in units of TDC (time segments) is then given by:

$$fP = mod\left(\frac{f_{LO}}{f_{REF}}, 1\right) \cdot P_{eff}.$$

It should further be noted that the value of $TDC_{OUT}$ can be used to update both estimates $f_{LO}$ and $P_{eff}$ after every iteration (sampling cycle).

The method 600 includes operating a TDC according to one or more aspects, e.g. TDC 300 and TDC 500. The method 600 further includes receiving 602 the sampled signals (e.g. first output signal 522 and second output signal 524) and/or the resulting encoded offset information. It is to be noted that the first output signal 522 and the second output signal 524 are analog signals. The outputs of both the first TDC 530 and the second TDC 540 are digital photographs of the above two signals taken at within several tens of picoseconds (32 picpseconds in the example) from REF signal edge appearing on the first signal 502 - this means they are vectors of "0" and "1" values (1 value per each sampler) Further, the method includes checking 604 if an edge has been registered (hit) or not. The method further includes, in case that no edge has been registered, checking 606 if the received samples (and/or encoded information) is made up of "all 0". If this is the case, then step_cand is set to the value $T_{smpl}$, else step_cand is set to the value $-T_{smpl}$. Furthermore, the method includes, if an edge has been registered, checking 608 if it is a different type of edge as the previous registered edge. In case it is a different type of edge step cand is set to the value $P_{eff}/2$, else step cand is set to zero.

Further, the method includes calculating 610 the following loop:

- If current_step equal zero, then next_step = step_cand. Otherwise, next_step = 0
- exp_tdc_out = mod($TDC_{OUT}$ - $fP$ + next step, $P_{eff}$)
- current_step = next_step

Lastly; the method includes outputting 612 the value exp_$TDC_{OUT}$.

Method 600 may be used to determine the next expected phase exp_$TDC_{OUT}$. Further logic may then be used to determine the best delays that a DTC, e.g. DTC 320 or DTC 520, may use in order to have the largest chance of finding (intercepting) the edge of the second signal 504 as described by the expected output phase. Further, frequency uncertainty can easily be bounded by using a measurement mechanism external to the TDC, such as e.g. a simple cycle counter with the frequency uncertainty being inversely proportional to the measurement time. It can easily be shown that for a GHz frequency LO signal, a 0.1% frequency uncertainty is obtained after measurement lasting several microseconds. Such an uncertainty translates to several hundreds femtosecond of cycle time uncertsainty, which is typcially under the (required) resolution scale of a TDC such as e.g. TDC 500. Method 600 may be used (is robust to) with initial frequency errors of 1% or even above 1%.

In the basic mode of operation of TDC 500, and assuming $N_{smpl}$ sampling circuits in each time segment, the possible processing outcomes of TDC 530 and TDC 540 (and/or encoders 550 and 560) in a given iteration are the following:

- All "0" - all sampled bits ($a_i$, $i \in [1, N_{smpl}]$) have 0 value.
- All "1" - all sampled have a value of 1.
- Rising edge - the sum fo the first half of the sampled bits is smaller than the sum of the second half of the sampled bits.
-
$$OFFST = N_{smpl} - \sum_{i=1}^{N_{smpl}} a_i$$
- Falling edge - the sum of the first half of the sampled bits is larger than the sum of the second half of the sampled bits.
-
$$OFFST = \sum_{i=1}^{N_{smpl}} a_i$$

The first and second encoders 550 and 560 may then output the first and second offset information to a controller 570. Controller 570 may include one or more processors (not shown). Controller 570 is configured to determine, at a current iteration and on the basis of the received offset information, a first time segment and a second time segment and to output pointer, PNTR, information to the DTC 520. The PNTR information is information indicative of which time segment (first or second) is assigned (to first and second output signals) in the next iteration by the DTC 520. Accordingly, the first PNTR information 572 is information indicative of the first time segment and the second PNTR information 574 is information indicative of the second time segment. The PNTR information may further be indicative of a delay to apply to each time segment in subsequent(s) iterations, i.e. the DTC 520 may be configured to apply the indicated delay to output signals 522 and 524 in subsequent iterations. Further, controller 570 may be configured to determine and output a value $TDC_{OUT}$ indicative of the phase difference between the first signal 502 and the second signal 504.

Further, the PNTR information from previous iterations may be used by controller 570 in the determination of the first and second time segments and/or of a delay to be applied to each time segment (signal) by DTC 520 in subsequent iterations.

The controller 570 may further be configured to determine an approximate phase based on the expected TDC bin-width $BW = \frac{T_{smpl}}{N_{smpl}}$:

$$TDC_{OUT,k} = (PNTR_k - 1) * T_{delay} + BW * OFFST_k \ (1),$$

where $PNTR_k$ is the pointer value provided to time segment *k,* $T_{smpl}$ is the length of each time (sampling) segment and $T_{delay}$ is the distance between the beginnings of two adjacents time segments (i.e.$T_{delay}$ = $T_{smpl}$ - overlap). In other words: k = 1 indicates the first time segment and k = 2 indicates the second time segment.

Controller 570 may be configured to use the above formula (1) for phase approximation (estimation) whenever calibration is not available.

TDC 500 may further include a memory 580 in which one or more lookup tables may be stored, e.g. one or more calibration lookup tables.

Controller 570 may further be configured to generate an address into memory 580 in the following manner:

$$ADDR_k = (PNTR_k - 1) * N_{smpl} + OFFST_k.$$

Controller 570 may be configured, once calibration becomes available, to use the information stored in memory 580 to obtain a more precise estimate of the measured phase (difference between the respective signals).

In the basic mode of operation, there are several possible outcomes in each sampling cycle, starting from an edge found in each time segment, through an edge found in one of the segments to no edges found at all. If at least one edge has been found, computing the phase outcome $TDC_{OUT}$ involves transforming $TDC_{OUT,k}$ of formula (1) to the same edge type if needed (assuming the edge types are separated by $P_{eff}/2$, with $P_{eff}$ being the effective cycle length in TDC (time segments) units) and unwrapping the phase (by $P_{eff}$) of different cycles edges (this is necessary in case an edge was found in time segments distanced by more than $P_{eff}/2$).

In case no edges are found in a given iteration, the phase location may be determined in the following manner:

- In case both sampled time segments are "all 0" (i.e. the phase is still "ahead"), then:

$$TDC_{OUT} = (PNTR_2 - 1) * T_{delay} + T_{smpl};$$

- If at least of the sampled time segments is "all 1", then

$$TDC_{OUT} = (PNTR_k - 1) * T_{delay};$$

  with k denoting the time segment featuring the "all 1" state.

TDC 500 may further be configured to perform a calibration method (process) based on a stochastic extraction principle. The calibration method may be performed by one or more processors (not shown) and/or by controller 570, e.g. by one or more processor(s) of controller 570. The resulting calibration information is stored in (a lookup table in) memory 580. The calibration method is performed at a certain calibration frequency.

The one or more processors (not shown) and/or controller 570 may be configured to determine a new value to use in future iterations for the partial overlap of the first time segment and the second time segment for another frequency based on the value of the partial overlap of the first time segment and the second time segment determined in the calibration method performed at a certain calibration frequency and stored in memory 580.

In the basic mode of operation of e.g. TDC 500, the calibration method has to be preceded by a procedure (method) to ensure that only edges of the desired type (rising or falling) are sampled, and that none are missed. For example, method 600 may be performed before the calibration method.

The calibration method includes the following two stages:

First stage: Accumulation of samples in order to form a phase probability distribution function:

a) In a main lookup table, LUT, stored in memory 580 and with rows according to the number of adresses available, each cell has it's value increased by 1 every time an edge is registered at the address of this cell. In the case where both adjacent segments register an edge, both adresses are increased.
b) In an overlap lookup table, OVRLP, stored in memory 580 and with a number of rows equal to the number of possible delays provided by DTC 520 (= number of differently located time segments, e.g. 8 time segments in FIG. 4), each time an edge is registered in two conscutive time segments, the cell corresponding to the later segments is increased by 1.

Second stage: Transformation of the phase probability ditribution function formed in the first stage into a phase cumulative distribution function, phase CDF and normalization:

a) Reset the cumulative distribution function accumulator, ACC, to 0.
b) Perform a double loop:

i) external loop running across PNTR values, from 1 to $N_{delay}$;
ii) internal loop running across OFFST values, from 1 to $N_{smpl}$;
iii) each time the internal begins, subtract the value OVRLP[PNTR] from accumulator to account for overlap pahse loss;
iv) compute the relevant ADDR=(PNTR-1)*$N_{smpl}$ + OFFST
v) add LUT[ADDR] to the accumulator: ACC + LUT[ADDR]
vi) set LUT[ADDR] = ACC - LUT[ADDR]/2

c) After both loops complete, normalize the LUT by the number of smaples accumulated, ACC.

**FIG. 7** illustrates an example of the contents of the main lookup table, LUT stored in memory 580 at the end of a successful calibration method (procedure).

Clearly visible in FIG 7 are the phase setbacks caused by the overlap in actual sampling time between two time segments (provided with adjacent delays).

The above calibration method may be performed for both type (falling and rising) of signal edges.

In an advanced mode of operation of TDC 500, calibration has been performed for both type of edges. In the advanced mode of operation, the TDC 500 is configured to use each time segment to sample a different edge type. Further, in order for TDC 500 to use the advanced mode of operation, dynamic impairements of the segment sampling, in particular the dependence of actual sampling moments on the type of edge being sampled have to be resolved beforehand. The advanced mode of operation of e.g. TDC 500 enables, under optimal conditions, to further decrease the quantization noise power by a factor of 2 (since two independent phase measures can be produced in every iteration (in every reference clock cycle)).

**FIG. 8** illustrates an example of a DPLL including a TDC according to one or more aspects, such as e.g. TDC 300 illustrated in FIG. 3 or TDC 500 illustrated in FIG. 5.

The DPLL 800 includes a TDC 810 according to one or more aspects of the present disclosure or one or more examples described above. TDC 810 may e.g. be configured in the same way as TDC 300 or TDC 500. TDC 810 is further configured to generate an output value 812 ($TDC_{OUT}$) indicative of a phase difference between the first input signal 802 and the second input signal 804. The second input signal 804 may e.g. be generated by a controlled oscillator 820 within the DPLL 800. The DPLL 800 further includes a decoder circuit 830 configured to calculate, based on the output value 812 of the TDC 810, a current value 832 of the phase of the second input signal 804. The DPLL 800 further include a processing circuit 840 configured to calculate, based on the current value 832 of the phase of the second input signal 804, a predicted value 842 (in a next iteration) of the phase of the second input signal 804.

The decoder circuit, e.g. implemented as a phase detector, 830 may further calculate the phase error 834 of the second input signal 804 by comparing the current phase of the second input signal 804 to the required (desired) phase of the second input signal 804.

The DPLL 800 may further include a loop filter 850 for supplying, based on the calculated phase error 834 of the input second signal 804, a control word 852 to the controlled oscillator 820.

The processing circuit 840 may e.g. be configured to further calculate the predicted value 842 of the phase of the second input signal 804 based on a frequency of the (oscillation) input signal 804.

**FIG. 9** illustrates an examplary TDC 900 according to some aspects. As shown in FIG. 9, TDC 900 includes a delay circuit 910, e.g. a delay structure, e.g. a delay structure including delay elements, configured to delay a first signal 902 to generate a plurality of (successively) delayed first signals 902-1, 902-2, ..., 902-n. TDC 900 further includes a circuit 920, e.g. a signal generator, configured to generate a first analog oscillating signal 922 and a second analog oscillating signal 924 using an input second signal 904, whereby the second analog oscillating signal 924 is phase offset with respect to the first analog oscillating signal 922. It should be noted that the signals 922 and 924 may be periodic signals. TDC 900 further includes a first plurality of sampling circuits 912-1, 912-2, ..., 912-n, each configured to sample the first analog oscillating signal in accordance with an associated delayed first signal of the delayed first signals 902-1, 902-2, ..., 902-n, and a second plurality of sampling circuits 914-1, 914-2, ..., 914-n, each configured to sample the second analog oscillating signal in accordance with an associated delayed first signal of the delayed first signals 902-1, 902-2, ..., 902-n, whereby each of the delayed first signals 902-1, 902-2, ..., 902-n is provided to a respective sample circuit of the first plurality of sample circuits 912-1, 912-2, ..., 912-n and to a respective sample circuit of the second plurality of sample circuits 914-1, 914-2, ..., 914-n.

**FIG. 10** shows a flowchart illustrating a method 1000 for operating a TDC according to some aspects, e.g. TDC 300 illustrated in FIG. 3 or TDC 500 illustrated in FIG. 5. As shown in FIG. 10, method 1000 includes delaying 1002 a first signal to generate a plurality of delayed first signals; generating 1004 a first analog oscillating signal and a second analog oscillating signal using an input second signal, wherein the second analog oscillating signal is phase offset with respect to the first analog oscillating signal; using 1006 a first plurality of sample circuits, sampling the first analog oscillating signal in accordance with an associated delayed first signal of the delayed first signals; and using 1008 a second plurality of sample circuits, sampling the second analog oscillating signal in accordance with an associated delayed first signal of the delayed first signals, wherein each of the delayed first signals is provided to a respective sample circuit of the first plurality of sample circuits and to a respective sample circuit of the second plurality of sample circuits.

**FIG. 11** shows a flowchart illustrating a method 1100 for operating a TDC according to some aspects, e.g. TDC 300 illustrated in FIG. 3 or TDC 500 illustrated in FIG. 5. As shown in FIG. 11, method 1100 includes delaying 1102 a first signal to generate a plurality of successively delayed first signals; generating 1104 a first periodic signal and a second periodic signal based on a second signal, wherein the second periodic signal is phase offset with respect to the first periodic signal; using 1106 a first plurality of sample elements, sampling the first periodic signal in accordance with an associated delayed first signal; and using 1108 a second plurality of sample elements, sampling the second periodic signal in accordance with an associated delayed first signal, wherein each of the delayed first signals is provided to a respective sample element of the first plurality of sample elements and to a respective sample element of the second plurality of sample elements.

**FIG. 12** shows a flowchart illustrating a method 1200 for operating a TDC according to some aspects, e.g. TDC 300 illustrated in FIG. 3 or TDC 500 illustrated in FIG. 5, wherein a time period including the dynamic range is divided into at least three time segments, wherein each of adjacent time segments overlap by a predefined overlap time period. As shown in FIG. 12, method 1200 includes delaying 1202 a first signal to generate a plurality of delayed first signals; generating 1204 a first analog oscillating signal associated with a first selected time segment and a second analog oscillating signal associated with a second selected time segment based on a second signal, wherein the second analog oscillating signal is time delayed with respect to the first analog oscillating signal; using 1206 a first plurality of samplers, sampling the first analog oscillating signal in accordance with an associated delayed first signal; using 1208 a second plurality of samplers, sampling the second analog oscillating signal in accordance with an associated delayed first signal, and iteratively selecting 1210, based on the content of the first plurality of samplers and the content of the second plurality of samplers for a current iteration, a first time segment from the at least three time segments and a second time segment from the at least three time segments, wherein the second time segment is cyclically adjacent to the first time segment.

While the above descriptions and connected figures may depict electronic device components as separate elements, skilled persons will appreciate the various possibilities to combine or integrate discrete elements into a single element. Such may include combining two or more circuits for form a single circuit, mounting two or more circuits onto a common semiconductor chip or chassis to form an integrated element, executing discrete software components on a common processor core, etc. Conversely, skilled persons will recognize the possibility to separate a single element into two or more discrete elements, such as splitting a single circuit into two or more separate circuits, separating a semiconductor chip or chassis into discrete elements originally provided thereon, separating a software component into two or more sections and executing each on a separate processor core, etc.

It is appreciated that implementations of methods detailed herein are demonstrative in nature, and are thus understood as capable of being implemented in a corresponding device. Likewise, it is appreciated that implementations of devices detailed herein are understood as capable of being implemented as a corresponding method. It is thus understood that a device corresponding to a method detailed herein may include one or more components configured to perform each aspect of the related method.

All acronyms defined in the above description additionally hold in all claims included herein

The following examples disclose various aspects of this disclosure:

Example 1 is a time-to-digital converter. The time-to-digital converter may include a delay circuit configured to delay a first signal to generate a plurality of delayed first signals; a circuit configured to generate a first analog oscillating signal and a second analog oscillating signal using an input second signal, wherein the second analog oscillating signal is phase offset with respect to the first analog oscillating signal; a first plurality of sample circuits, each configured to sample the first analog oscillating signal in accordance with an associated delayed first signal of the delayed first signals, and a second plurality of sample circuits, each configured to sample the second analog oscillating signal in accordance with an associated delayed first signal of the delayed first signals. Each of the delayed first signals is provided to a respective sample circuit of the first plurality of sample circuits and to a respective sample circuit of the second plurality of sample circuits.

In Example 2, the subject matter of Example 1 can optionally include that the first and second analog oscillating signal is a periodic signal.

In Example 3, the subject matter of any one of Examples 1 or 2 can optionally include that the first analog oscillating signal is assigned to a first time segment of a time period including a dynamic range of the time-to-digital converter. The second analog oscillating signal is assigned to a second time segment of a time period comprising a dynamic range of the time-to-digital converter.

In Example 4, the subject matter of Example 3 can optionally include that the first time segment and the second time segment partially overlap.

In Example 5, the subject matter of Example 4 can optionally include that the time-to-digital converter further includes a memory storing a calibration information representing a value of the partial overlap of the first time segment and the second time segment determined in a calibration process performed at a calibration frequency.

In Example 6, the subject matter of Example 5 can optionally include that the time-to-digital converter further includes a processor configured to determine a new value of the partial overlap of the first time segment and the second time segment for another frequency based on the value of the partial overlap of the first time segment and the second time segment determined in a calibration process performed at a calibration frequency stored in the memory.

In Example 7, the subject matter of any one of Examples 1 to 6 can optionally include that the first signal is a reference signal and the second signal is an oscillating signal.

In Example 8, the subject matter of any one of Examples 1 to 6 can optionally include that the first signal is an oscillating signal and the second signal is a reference signal.

In Example 9, the subject matter of any one of Examples 1 to 8 can optionally include that the delay circuit is configured to delay the first signal successively by one or more predefined delay times.

In Example 10, the subject matter of any one of Examples 1 to 9 can optionally include that the delay circuit includes a plurality of delay elements. Each delay element is configured to delay a signal by a predefined time.

In Example 11, the subject matter of any one of Examples 1 to 10 can optionally include that the circuit is a digital-to-time converter.

In Example 12, the subject matter of any one of Examples 1 to 11 can optionally include that the time-to-digital converter further incudes a lookup table configured to store information representative of the phase difference between the first signal and the second signal.

In Example 13, the subject matter of any one of Examples 1 to 12 can optionally include that the time-to-digital converter further including an encoding circuit configured to encode the content of the first plurality of sample circuits to generate first offset information and to encode the content of the second plurality of sample circuits to generate second offset information.

In Example 14, the subject matter of any one of Examples 1 to 13 can optionally include that the time-to-digital converter has a dynamic range. A time period includes the dynamic range and is divided into at least three time segments. Each of adjacent time segments overlap by a predefined overlap time period. The time-to-digital converter further includes a controller configured to determine, based on the content of the first plurality of sample circuits and the content of the second plurality of sample circuits at a current iteration, a first time segment from the at least three time segments and a second time segment from the at least three time segments, wherein the second time segment is cyclically adjacent to the first time segment, and instruct the circuit to assign the first time segment to the first analog oscillating signal to be sampled in a subsequent iteration and to assign the second time segment to the second analog oscillating signal to be sampled in the subsequent iteration.

In Example 15, the subject matter of Example 14 can optionally include that the controller is further configured to determine a value indicative of a phase difference between the first and second signal based on the sampled first and second analog oscillating signals.

In Example 16, the subject matter of any one of Examples 14 or 16 can optionally include that the controller is further configured to generate an address in a lookup table on the basis of the sampled first and second analog oscillating signals.

Example 17 is a digital phase-locked loop. The digital phase-locked loop may include a time-to-digital converter according to any one of Examples 1 to 16. The time-to-digital converter is further configured to generate an output value indicative of a phase difference between the first signal and the second signal. The second signal is generated by a controlled oscillator comprised within the digital phase-locked loop. The digital phase-locked loop may further include a phase detector configured to calculate, based on the output value generated by the time-to-digital converter, the current value of the phase of the second signal; and a processing circuit configured to calculate, based on the current value of the phase of the second signal, a predicted value of the phase of the second signal.

In Example 18, the subject matter of Example 17 can optionally include that the processing circuit is further configured to calculate the predicted value of the phase of the second signal based on the current value of the phase of the second signal and based on a frequency of the second signal.

Example 19 is a time-to-digital converter. The time-to-digital converter may include a delay structure configured to delay a first signal to generate a plurality of successively delayed first signals; a circuit configured to generate a first periodic signal and a second periodic signal based on a second signal, wherein the second periodic signal is phase offset with respect to the first periodic signal; a first plurality of sample elements, each configured to sample the first periodic signal in accordance with an associated delayed first signal; and a second plurality of sample elements, each configured to sample the second periodic signal in accordance with an associated delayed first signal. Each of the delayed first signals is provided to a respective sample element of the first plurality of sample elements and to a respective sample element of the second plurality of sample elements.

In Example 20, the subject matter of Example 19 can optionally include that the first analog periodic signal is assigned to a first time segment of a time period comprising a dynamic range of the time-to-digital converter. The second analog periodic signal is assigned to a second time segment of a time period comprising a dynamic range of the time-to-digital converter.

In Example 21, the subject matter of Example 20 can optionally include that the first time segment and the second time segment partially overlap.

In Example 22, the subject matter of Example 21 can optionally include that the time-to-digital converter further includes a memory storing a calibration information representing a value of the partial overlap of the first time segment and the second time segment determined in a calibration process performed at a calibration frequency.

In Example 23, the subject matter of Example 22 can optionally include that the time-to-digital converter further includes a processor configured to determine a new value of the partial overlap of the first time segment and the second time segment for another frequency based on the value of the partial overlap of the first time segment and the second time segment determined in a calibration process performed at a calibration frequency stored in the memory.

In Example 24, the subject matter of any one of Examples 19 to 23 can optionally include that the first signal is a reference signal and the second signal is an oscillating signal provided by a local oscillator.

In Example 25, the subject matter of any one of Examples 19 to 23 can optionally include that the first signal is an oscillating signal provided by a local oscillator and the second signal is a reference signal.

In Example 26, the subject matter of any one of Examples 19 to 25 can optionally include that the delay structure is configured to delay the first signal successively by one or more predefined delay times.

In Example 27, the subject matter of any one of Examples 19 to 26 can optionally include that the delay structure comprises a plurality of delay elements. Each delay element is configured to delay a signal by a predefined time.

In Example 28, the subject matter of any one of Examples 19 to 27 can optionally include that the circuit is a digital-to-time converter.

In Example 29, the subject matter of any one of Examples 19 to 28 can optionally include that the time-to-digital converter further includes an encoding circuit configured to encode the content of the first plurality of sample elements to generate first offset information and to encode the content of the second plurality of sample elements to generate second offset information.

In Example 30, the subject matter of any one of Examples 19 to 29 can optionally include that the time-to-digital converter further includes a lookup table configured to store information representative of the phase difference between the first signal and the second signal, and preferably configured to use the first offset information and/or the second offset information as a part of an address in the lookup table.

In Example 31, the subject matter of any one of Examples 19 to 30 can optionally include that the time-to-digital converter has a dynamic range. A time period includes the dynamic range and is divided into at least three time segments. Each of adjacent time segments overlap by a predefined overlap time period. The time-to-digital converter may further include a controller configured to determine, based on the content of the first plurality of sample elements and the content of the second plurality of sample elements at a current iteration, a first time segment from the at least three time segments and a second time segment from the at least three time segments. The second time segment is cyclically adjacent to the first time segment, and instruct the circuit to assign the first time segment to the first analog oscillating signal to be sampled in a subsequent iteration and to assign the second time segment to the second analog oscillating signal to be sampled in the subsequent iteration.

In Example 32, the subject matter of Example 31 can optionally include that the controller is further configured to determine a value indicative of a phase difference between the first and second signal based on the sampled first and second analog periodic signals.

In Example 33, the subject matter of any one of Examples 31 or 32 can optionally include that the controller is further configured to generate an address in a lookup table on the basis of the sampled first and second analog periodic signals.

Example 34 is a digital phase-locked loop. The digital phase-locked loop may include a time-to-digital converter according to any one of Examples 19 to 33. The time-to-digital converter is further configured to generate an output value indicative of a phase difference between the first signal and the second signal, wherein the second signal is generated by a controlled oscillator comprised within the digital phase-locked loop. The digital phase-locked loop may further include a phase detector configured to calculate, based on the output value generated by the time-to-digital converter, the current value of the phase of the second signal; and a processing circuit configured to calculate, based on the current value of the phase of the second signal, a predicted value of the phase of the second signal.

In Example 35, the subject matter of Example 34 can optionally include that the processing circuit is further configured to calculate the predicted value of the phase of the second signal based on the current value of the phase of the second signal and based on a frequency of the second signal.

Example 36 is a time-to-digital converter having a dynamic range. A time period includes the dynamic range and is divided into at least three time segments. Each of cyclically adjacent time segments overlap by a predefined overlap time period. The time-to-digital converter may include a delay structure configured to delay a first signal to generate a plurality of delayed first signals; a signal generator configured to generate a first analog oscillating signal associated with a first selected time segment and a second analog oscillating signal associated with a second selected time segment based on a second signal. The second analog oscillating signal is time delayed with respect to the first analog oscillating signal. The time-to-digital converter may further include a first plurality of samplers, each sampler configured to sample the first analog oscillating signal in accordance with an associated delayed first signal; and a second plurality of samplers, each sampler configured to sample the second analog oscillating signal in accordance with an associated delayed first signal, and a time segment selector configured to successively_select, based on the content of the first plurality of samplers and the content of the second plurality of samplers for a current iteration, a first time segment from the at least three time segments and a second time segment from the at least three time segments. The second time segment is cyclically adjacent to the first time segment.

In Example 37, the subject matter of Example 36 can optionally include that the first and second analog oscillating signal is a periodic signal.

In Example 38, the subject matter of any one of Examples 36 or 37 can optionally include that the time-to-digital converter further includes a memory storing a calibration information representing a value of the partial overlap of the first time segment and the second time segment determined in a calibration process performed at a calibration frequency.

In Example 39, the subject matter of Example 38 can optionally include that the time-to-digital converter further includes a processor configured to determine a new value of the partial overlap of the first time segment and the second time segment for another frequency based on the value of the partial overlap of the first time segment and the second time segment determined in a calibration process performed at a calibration frequency stored in the memory.

In Example 40, the subject matter of any one of Examples 36 to 39 can optionally include that the first signal is a reference signal and the second signal is an oscillating signal.

In Example 41, the subject matter of any one of Examples 36 to 39 can optionally include that the first signal is an oscillating signal and the second signal is a reference signal.

In Example 42, the subject matter of any one of Examples 36 to 41 can optionally include that the delay structure is configured to delay the first signal successively by one or more predefined delay times.

In Example 43, the subject matter of any one of Examples 36 to 42 can optionally include that the delay structure includes a plurality of delay elements. Each delay element is configured to delay a signal by a predefined time.

In Example 44, the subject matter of any one of Examples 36 to 43 can optionally include that the signal generator is a digital-to-time converter.

In Example 45, the subject matter of any one of Examples 36 to 44 can optionally include that the time-to-digital converter further includes an encoding circuit configured to encode the content of the first plurality of samplers to generate first offset information and to encode the content of the second plurality of samplers to generate second offset information.

In Example 46, the subject matter of any one of Examples 36 to 45 can optionally include that the time-to-digital converter further includes a lookup table configured to store information representative of the phase difference between the first signal and the second signal, and preferably configured to use the first offset information and/or the second offset information as a part of an address in the lookup table.

In Example 47, the subject matter of any one of Examples 36 to 46 can optionally include that the time-to-digital converter further includes a controller configured to determine a value indicative of a phase difference between the first and second signal based on the sampled first and second analog oscillating signals.

In Example 48, the subject matter of Example 47 can optionally include that the controller is further configured to generate an address in a lookup table on the basis of the sampled first and second analog oscillating signals.

Example 49 is a digital phase-locked loop. The digital phase-locked loop may include a time-to-digital converter according to any one of Examples 36 to 48. The time-to-digital converter is further configured to generate an output value indicative of a phase difference between the first signal and the second signal. The second signal is generated by a controlled oscillator comprised within the digital phase-locked loop. The digital phase-locked loop may further include a phase detector configured to calculate, based on the output value generated by the time-to-digital converter, the current value of the phase of the second signal; and a processing circuit configured to calculate, based on the current value of the phase of the second signal, a predicted value of the phase of the second signal.

In Example 50, the subject matter of Example 49 can optionally include that the processing circuit is further configured to calculate the predicted value of the phase of the second signal based on the current value of the phase of the second signal and based on a frequency of the second signal.

Example 51 is a method for operating a time-to-digital converter. The method may include delaying a first signal to generate a plurality of delayed first signals; generating a first analog oscillating signal and a second analog oscillating signal using an input second signal, wherein the second analog oscillating signal is phase offset with respect to the first analog oscillating signal; using a first plurality of sample circuits, sampling the first analog oscillating signal in accordance with an associated delayed first signal of the delayed first signals, and using a second plurality of sample circuits, sampling the second analog oscillating signal in accordance with an associated delayed first signal of the delayed first signals. Each of the delayed first signals is provided to a respective sample circuit of the first plurality of sample circuits and to a respective sample circuit of the second plurality of sample circuits.

Example 52 is a method for operating a time-to-digital converter. The method may include delaying a first signal to generate a plurality of successively delayed first signals; generating a first periodic signal and a second periodic signal based on a second signal, wherein the second periodic signal is phase offset with respect to the first periodic signal; using a first plurality of sample elements, sampling the first periodic signal in accordance with an associated delayed first signal; and using a second plurality of sample elements, sampling the second periodic signal in accordance with an associated delayed first signal. Each of the delayed first signals is provided to a respective sample element of the first plurality of sample elements and to a respective sample element of the second plurality of sample elements.

Example 53 is a method for operating a time-to-digital converter having a dynamic range. A time period includes the dynamic range and is divided into at least three time segments. Each of adjacent time segments overlap by a predefined overlap time period. The method may include delaying a first signal to generate a plurality of delayed first signals; generating a first analog oscillating signal associated with a first selected time segment and a second analog oscillating signal associated with a second selected time segment based on a second signal, wherein the second analog oscillating signal is time delayed with respect to the first analog oscillating signal; using a first plurality of samplers, sampling the first analog oscillating signal in accordance with an associated delayed first signal; and using a second plurality of samplers, sampling the second analog oscillating signal in accordance with an associated delayed first signal, and iteratively selecting, based on the content of the first plurality of samplers and the content of the second plurality of samplers for a current iteration, a first time segment from the at least three time segments and a second time segment from the at least three time segments. The second time segment is cyclically adjacent to the first time segment.

While the invention has been particularly shown and described with reference to specific embodiments, it should be understood by those skilled in the art that various changes in form and detail may be made therein without departing from the spirit and scope of the invention as defined by the appended claims. The scope of the invention is thus indicated by the appended claims and all changes which come within the meaning and range of equivalency of the claims are therefore intended to be embraced.

## Claims

**1.** A time-to-digital converter, comprising:

a delay circuit configured to delay a first signal to generate a plurality of delayed first signals;
a circuit configured to generate a first analog oscillating signal and a second analog oscillating signal using an input second signal, wherein the second analog oscillating signal is phase offset with respect to the first analog oscillating signal;
a first plurality of sample circuits, each configured to sample the first analog oscillating signal in accordance with an associated delayed first signal of the delayed first signals,
a second plurality of sample circuits, each configured to sample the second analog oscillating signal in accordance with an associated delayed first signal of the delayed first signals,
wherein each of the delayed first signals is provided to a respective sample circuit of the first plurality of sample circuits and to a respective sample circuit of the second plurality of sample circuits.

**2.** The time-to-digital converter of claim 1,
wherein the first and second analog oscillating signal is a periodic signal.

**3.** The time-to-digital converter of any one of claims 1 or 2,
wherein the first analog oscillating signal is assigned to a first time segment of a time period comprising a dynamic range of the time-to-digital converter; wherein the second analog oscillating signal is assigned to a second time segment of a time period comprising a dynamic range of the time-to-digital converter.

**4.** The time-to-digital converter of claim 3,
wherein the first time segment and the second time segment partially overlap.

**5.** The time-to-digital converter of claim 4, further comprising:
a memory storing a calibration information representing a value of the partial overlap of the first time segment and the second time segment determined in a calibration process performed at a calibration frequency.

**6.** The time-to-digital converter of claim 5, further comprising:
a processor configured to determine a new value of the partial overlap of the first time segment and the second time segment for another frequency based on the value of the partial overlap of the first time segment and the second time segment determined in a calibration process performed at a calibration frequency stored in the memory.

**7.** The time-to-digital converter of any one of claims 1 to 6,
wherein the first signal is a reference signal and the second signal is an oscillating signal.

**8.** The time-to-digital converter of any one of claims 1 to 6,
wherein the first signal is an oscillating signal and the second signal is a reference signal.

**9.** The time-to-digital converter of any one of claims 1 to 8,
wherein the delay circuit is configured to delay the first signal successively by one or more predefined delay times.

**10.** The time-to-digital converter of any one of claims 1 to 9,
wherein the delay circuit comprises a plurality of delay elements, each delay element is configured to delay a signal by a predefined time; and/or

**11.** The time-to-digital converter of any one of claims 1 to 10, further comprising:

an encoding circuit configured to encode the content of the first plurality of sample circuits to generate first offset information and to encode the content of the second plurality of sample circuits to generate second offset information; and/or
a lookup table configured to store information representative of the phase difference between the first signal and the second signal, and preferably further configured to use the first offset information and/or the second offset information as a part of an address in the lookup table.

**12.** The time-to-digital converter of any one of claims 1 to 11,
wherein the time-to-digital converter has a dynamic range, wherein a time period comprising the dynamic range is divided into at least three time segments, wherein each of adjacent time segments overlap by a predefined overlap time period, the time-to-digital converter further comprising a controller configured to

determine, based on the content of the first plurality of sample circuits and the content of the second plurality of sample circuits at a current iteration, a first time segment from the at least three time segments and a second time segment from the at least three time segments, wherein the second time segment is cyclically adjacent to the first time segment, and
instruct the circuit to assign the first time segment to the first analog oscillating signal to be sampled in a subsequent iteration and to assign the second time segment to the second analog oscillating signal to be sampled in the subsequent iteration.

**13.** The time-to-digital converter of claim 12,

wherein the controller is further configured to determine a value indicative of a phase difference between the first and second signal based on the sampled first and second analog oscillating signals; and/or
wherein the controller is further configured to generate an address in a lookup table on the basis of the sampled first and second analog oscillating signals.

**14.** A digital phase-locked loop, comprising:

a time-to-digital converter according to any one of claims 1 to 13, wherein the time-to-digital converter is further configured to generate an output value indicative of a phase difference between the first signal and the second signal, wherein the second signal is generated by a controlled oscillator comprised within the digital phase-locked loop;
a phase detector configured to calculate, based on the output value generated by the time-to-digital converter, the current value of the phase of the second signal; and
a processing circuit configured to calculate, based on the current value of the phase of the second signal, a predicted value of the phase of the second signal.

**15.** The digital phase-locked-loop of claim 14,
wherein the processing circuit is further configured to calculate the predicted value of the phase of the second signal based on the current value of the phase of the second signal and based on a frequency of the second signal.

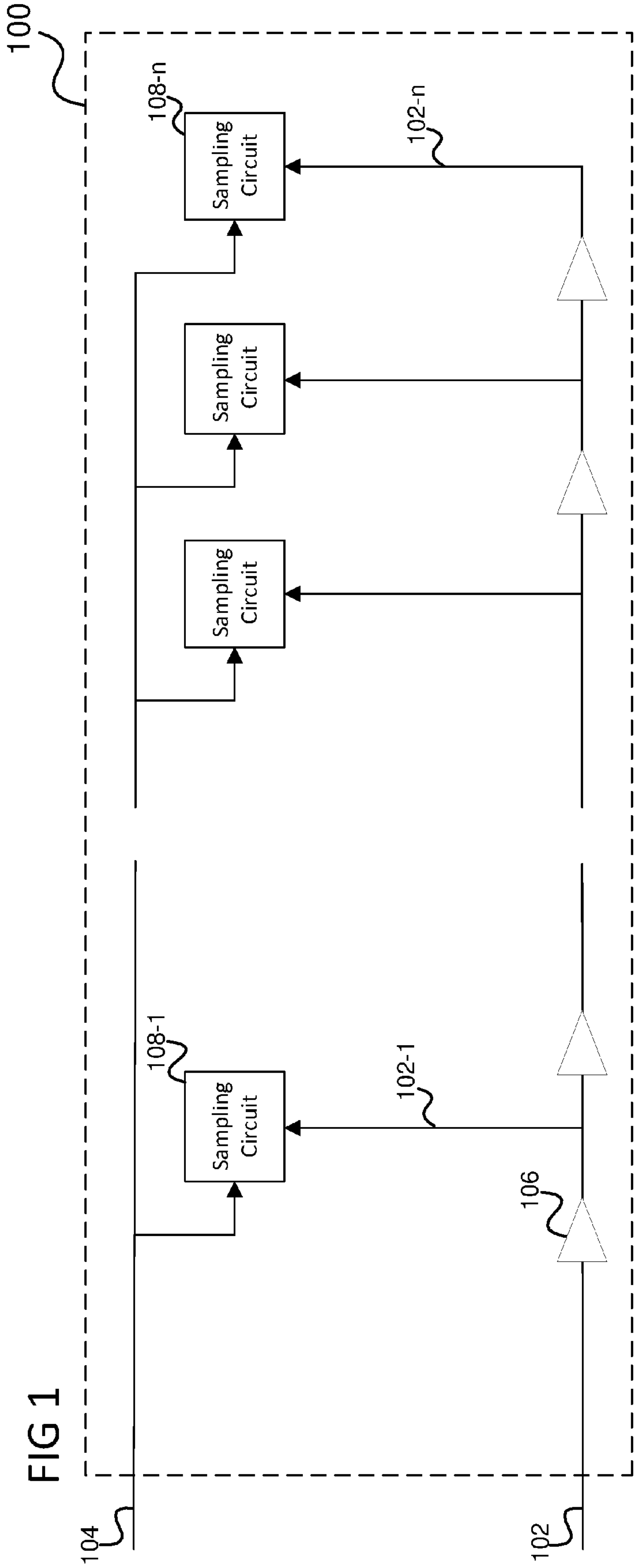
100
108-n
Sampling Circuit
102-n
Sampling Circuit
Sampling Circuit
108-1
Sampling Circuit
102-1
106
104
102

FIG 1

FIG 2

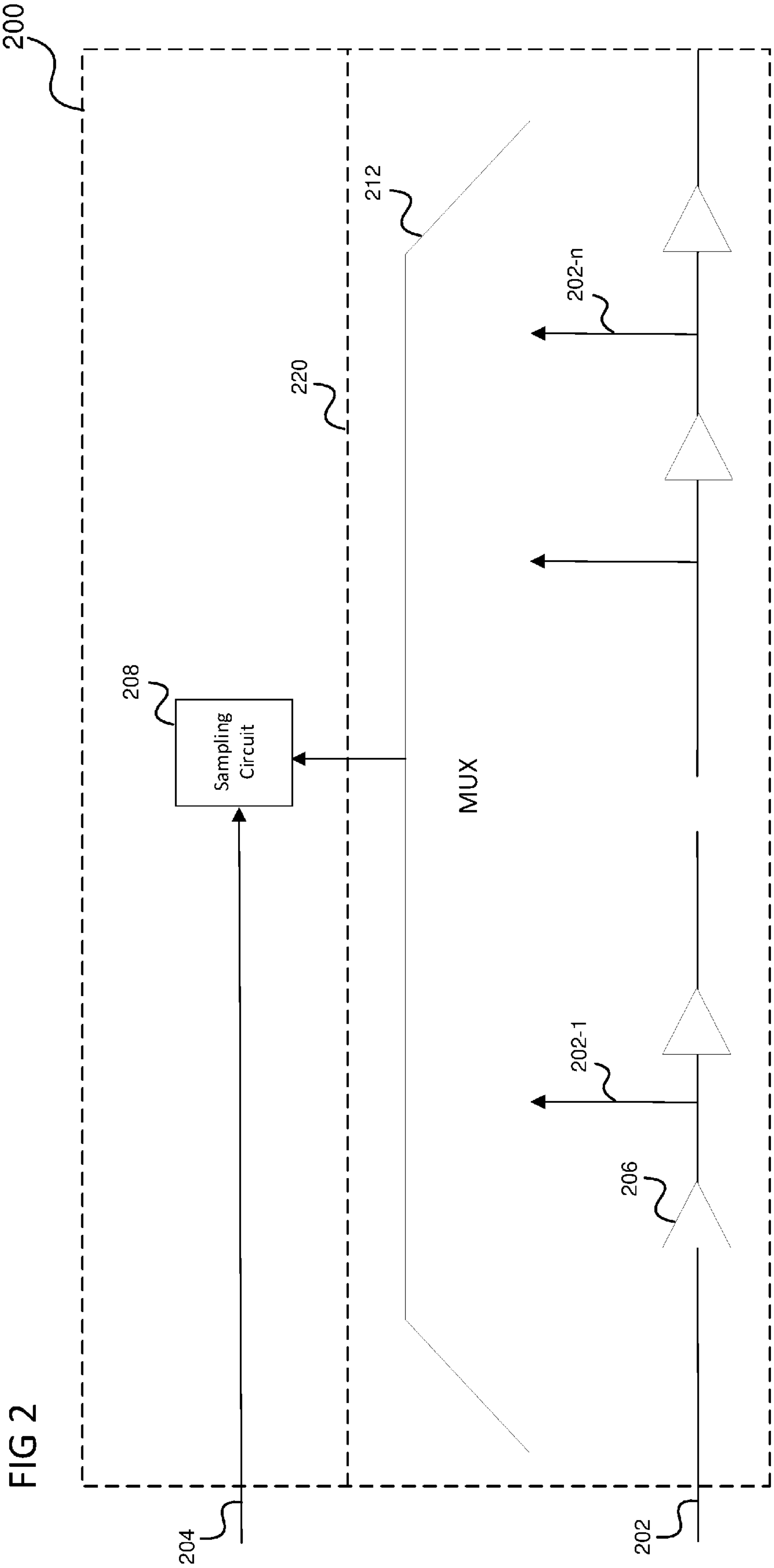

FIG 3

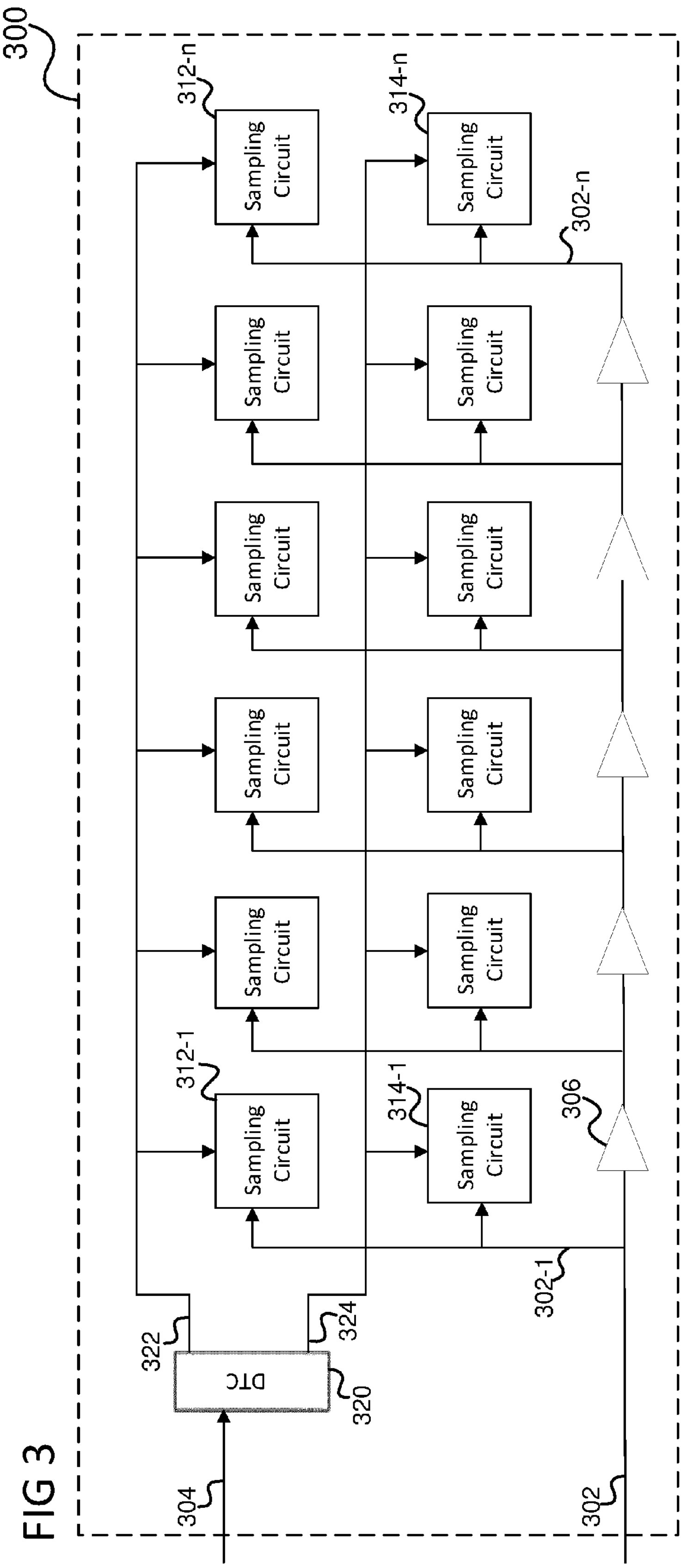
300
312-n
314-n
Sampling Circuit
302-n
312-1
314-1
306
302-1
DTC
322
324
320
304
302

FIG 4

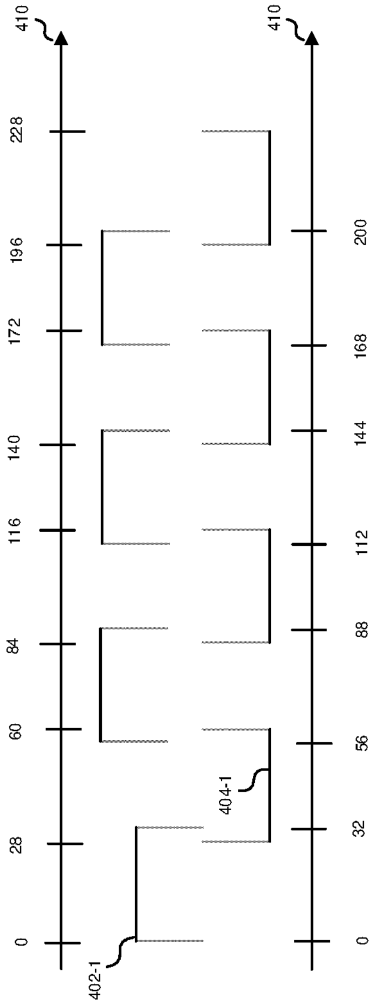

410
228
196
172
140
116
84
60
28
0
402-1
404-1
410
200
168
144
112
88
56
32
0

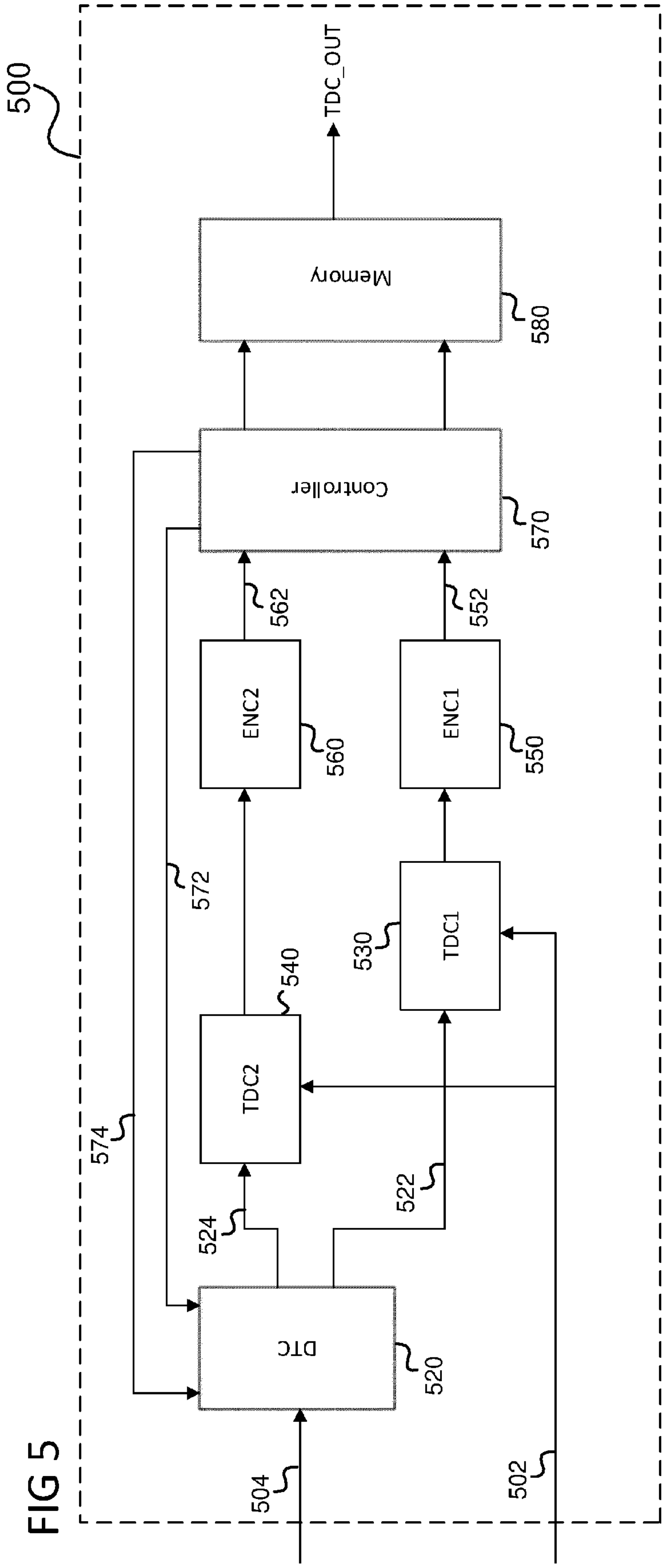
500
TDC_OUT
Memory
580
Controller
570
562
552
ENC2
560
ENC1
550
572
540
530
TDC1
TDC2
574
522
524
DTC
520
504
502

FIG 5

FIG 6

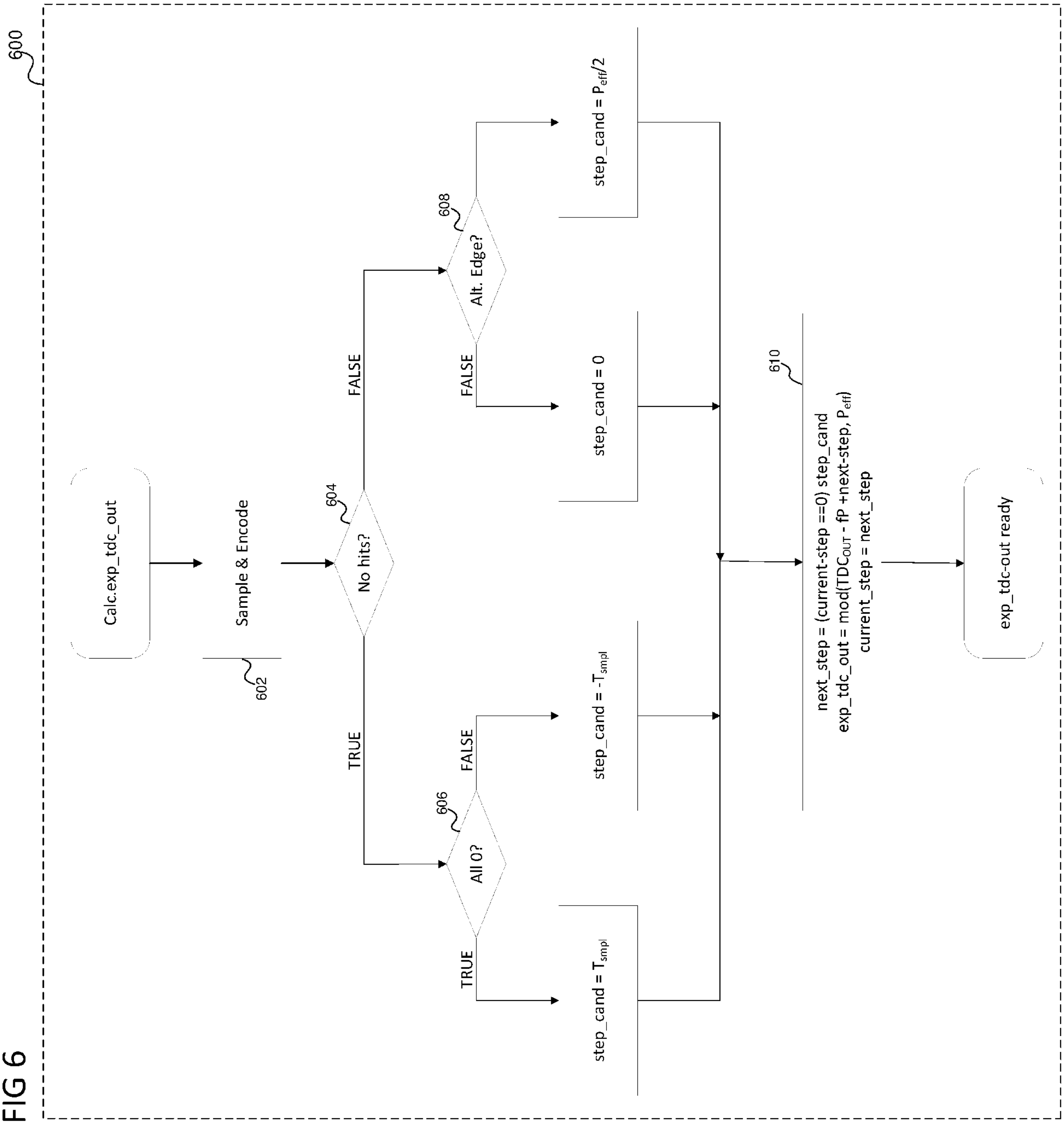
600
Calc.exp_tdc_out
Sample & Encode
602
No hits?
604
TRUE
FALSE
All 0?
606
Alt. Edge?
608
TRUE
FALSE
FALSE
step_cand = $T_{smpl}$
step_cand = $-T_{smpl}$
step_cand = 0
step_cand = $P_{eff}/2$
610
next_step = (current-step ==0) step_cand
exp_tdc_out = mod($TDC_{OUT}$ - fP +next-step, $P_{eff}$)
current_step = next_step
exp_tdc-out ready

FIG 7

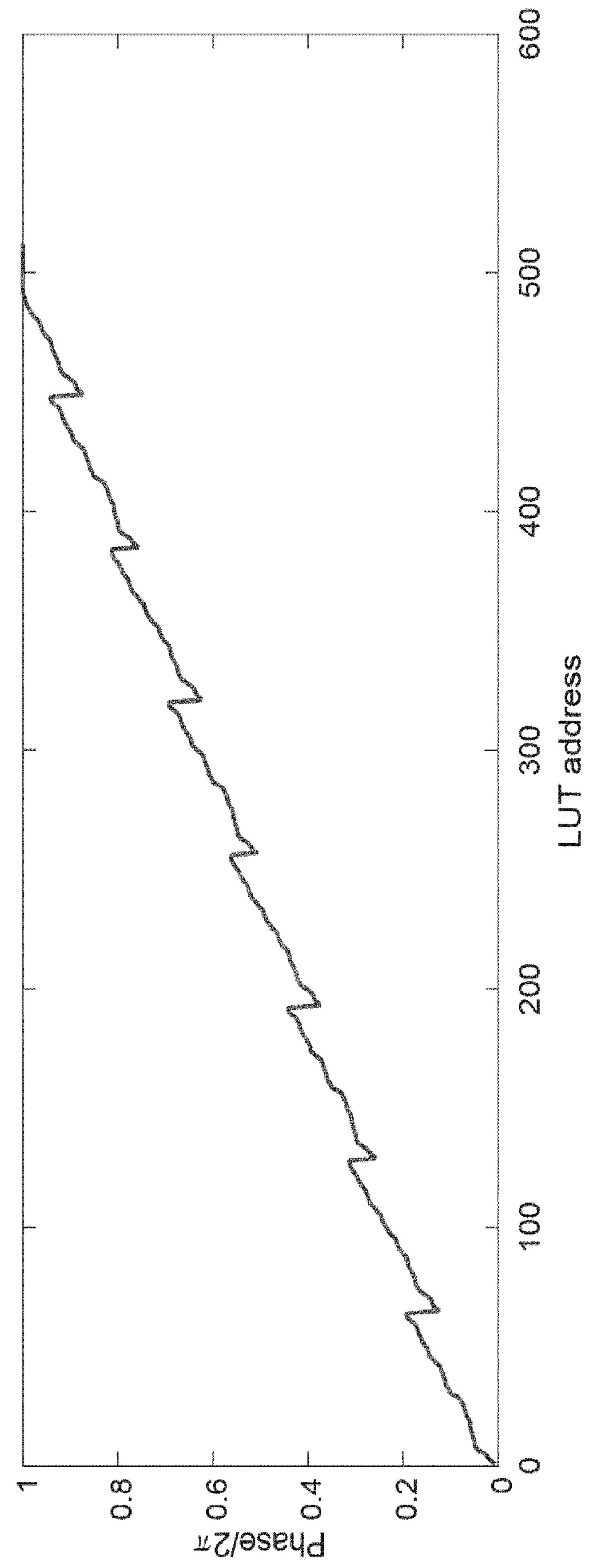


Exemplary CDF

FIG 8

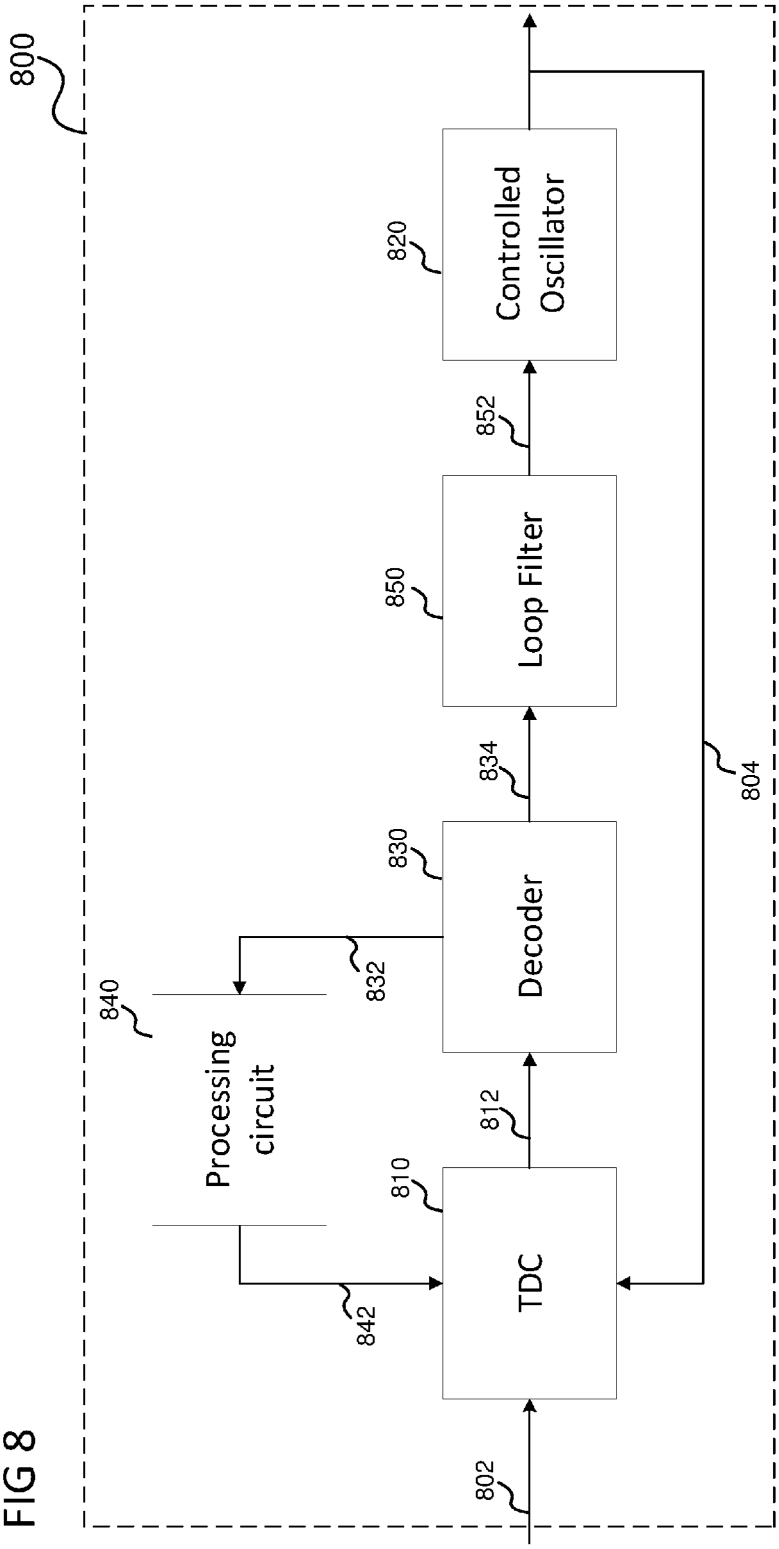
800
820
Controlled Oscillator
852
850
Loop Filter
834
804
830
Decoder
832
840
Processing circuit
812
810
TDC
842
802

FIG 9

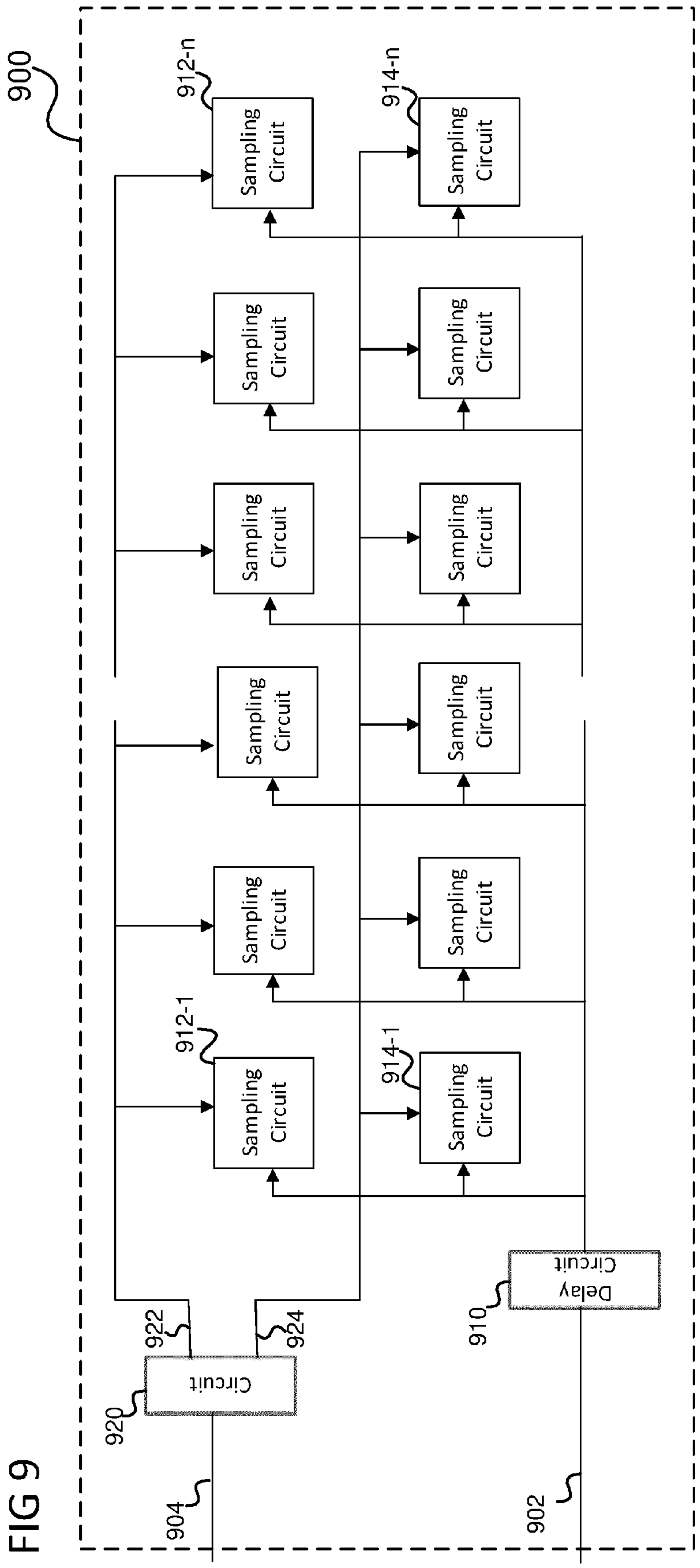
900
912-n
914-n
912-1
914-1
Sampling Circuit
Delay Circuit
Circuit
910
920
922
924
902
904

FIG 10

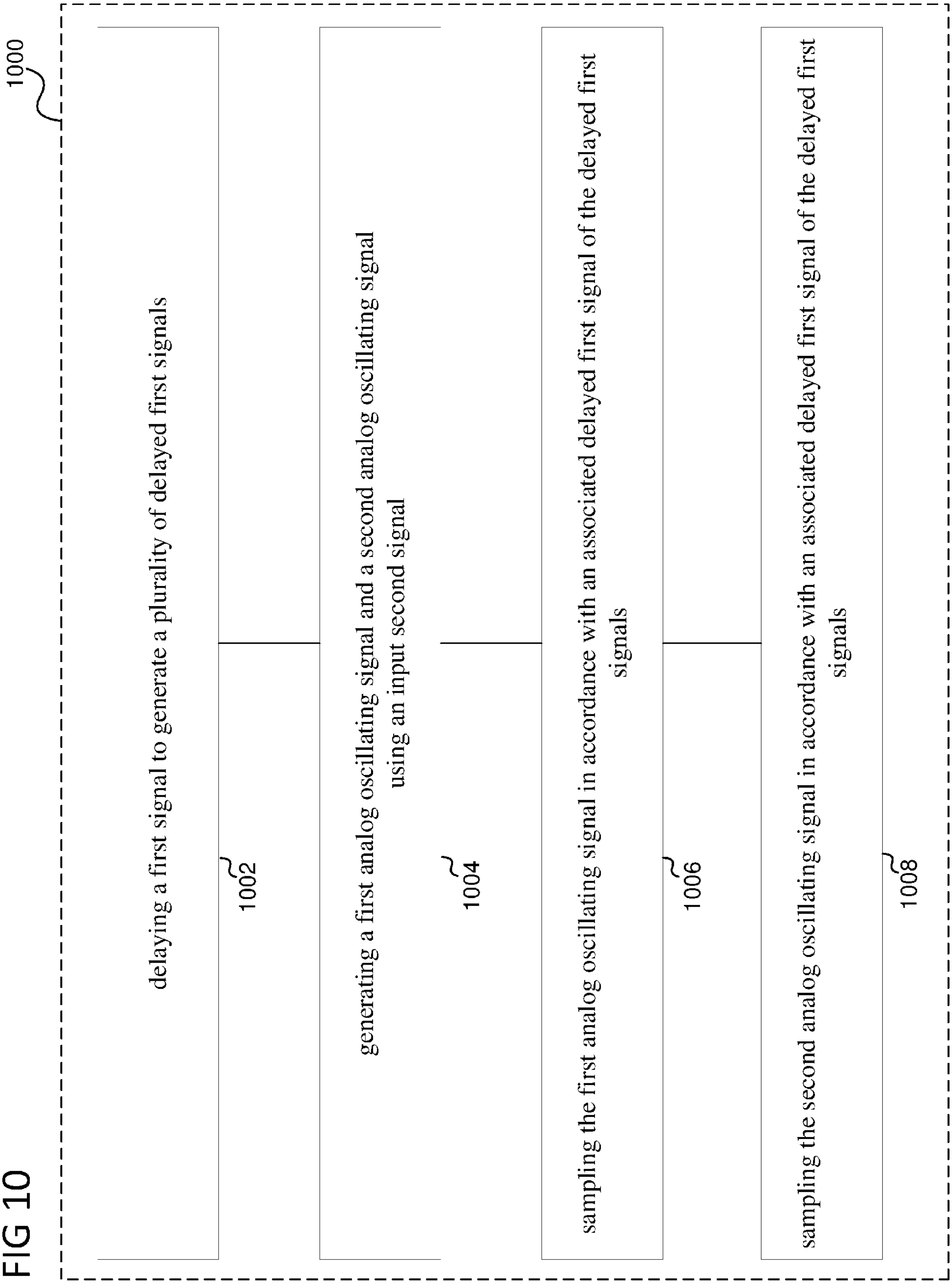
1000
delaying a first signal to generate a plurality of delayed first signals
1002
generating a first analog oscillating signal and a second analog oscillating signal using an input second signal
1004
sampling the first analog oscillating signal in accordance with an associated delayed first signal of the delayed first signals
1006
sampling the second analog oscillating signal in accordance with an associated delayed first signal of the delayed first signals
1008

FIG 11

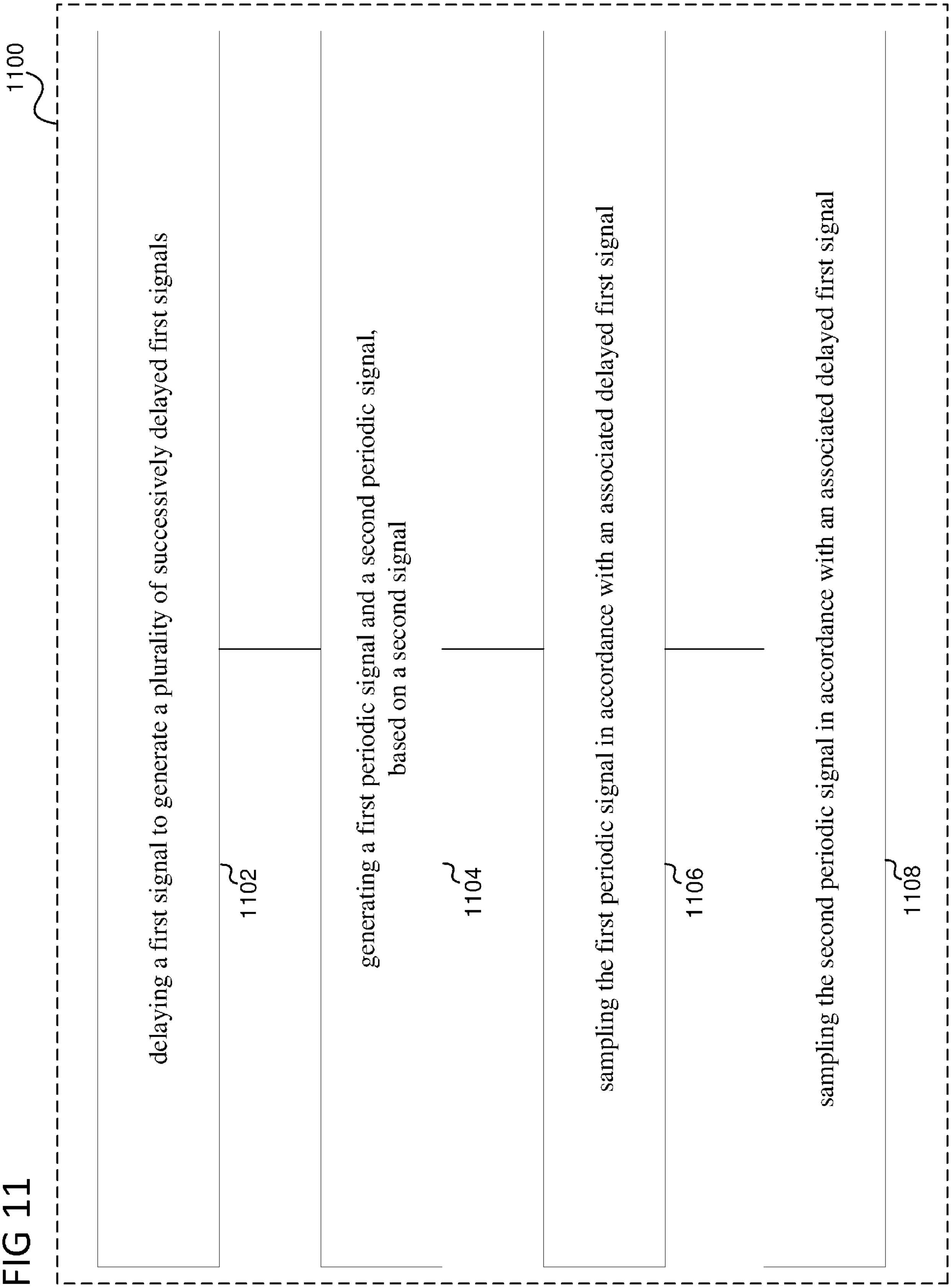
1100
delaying a first signal to generate a plurality of successively delayed first signals
1102
generating a first periodic signal and a second periodic signal, based on a second signal
1104
sampling the first periodic signal in accordance with an associated delayed first signal
1106
sampling the second periodic signal in accordance with an associated delayed first signal
1108

FIG 12

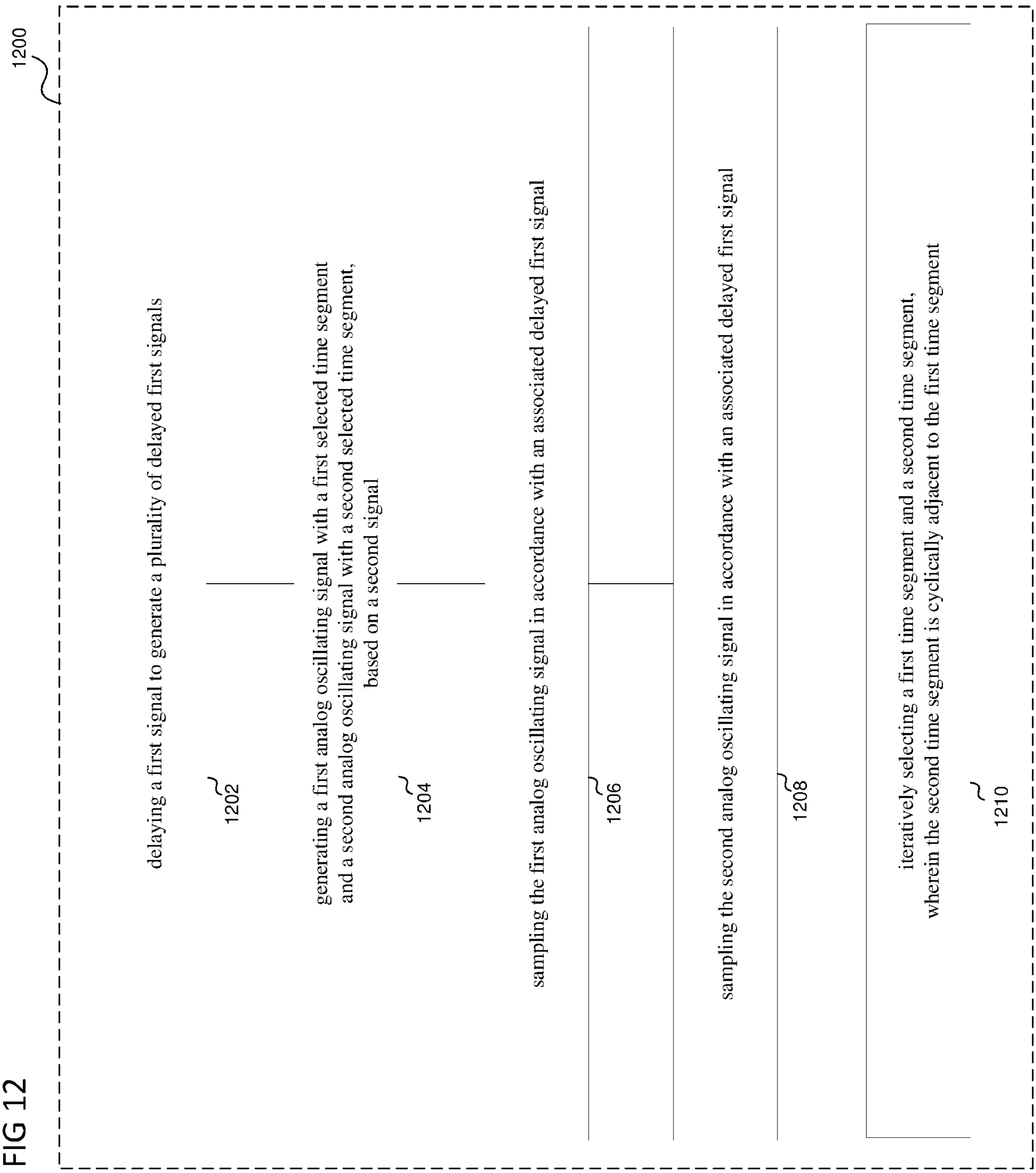
1200
delaying a first signal to generate a plurality of delayed first signals
1202
generating a first analog oscillating signal with a first selected time segment and a second analog oscillating signal with a second selected time segment, based on a second signal
1204
sampling the first analog oscillating signal in accordance with an associated delayed first signal
1206
sampling the second analog oscillating signal in accordance with an associated delayed first signal
1208
iteratively selecting a first time segment and a second time segment, wherein the second time segment is cyclically adjacent to the first time segment
1210

Europäisches Patentamt
European Patent Office
Office européen des brevets

# EUROPEAN SEARCH REPORT

Application Number
EP 22 19 7069

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 11 418 199 B1 (CHERNIAK DMYTRO [AT] ET AL) 16 August 2022 (2022-08-16)<br>* columns 6,7; figures 3A-4A *<br>----- | 1-15 | INV.<br>G04F10/00<br><br>ADD.<br>H03L7/08<br>H03L7/087 |
| X | US 2010/244971 A1 (WANG KEVIN H [US] ET AL) 30 September 2010 (2010-09-30)<br>* paragraphs [0044], [0063]; figures 1,2,5 *<br>----- | 1-9, 11-15 | |
| A | LEVINE P M ET AL: "High-resolution flash time-to-digital conversion and calibration for system-on-chip testing Embedded microelectronic systems: status and trends (Part 2)",<br>IEE PROCEEDINGS: COMPUTERS AND DIGITAL TECHNIQUES, IEE, GB,<br>vol. 152, no. 3, 6 May 2005 (2005-05-06), pages 415-426, XP006024722,<br>ISSN: 1350-2387, DOI: 10.1049/IP-CDT:20045063<br>* Section 2; Section 3; figure 6 *<br>----- | 1-15 | TECHNICAL FIELDS SEARCHED (IPC)<br>G04F<br>G04G<br>H03L |

The present search report has been drawn up for all claims

| Place of search | Date of completion of the search | Examiner |
|---|---|---|
| The Hague | 12 March 2023 | Jesus, Paulo |

1

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

## ANNEX TO THE EUROPEAN SEARCH REPORT ON EUROPEAN PATENT APPLICATION NO.

EP 22 19 7069

This annex lists the patent family members relating to the patent documents cited in the above-mentioned European search report. The members are as contained in the European Patent Office EDP file on
The European Patent Office is in no way liable for these particulars which are merely given for the purpose of information.

12-03-2023

| Patent document cited in search report | Publication date | Patent family member(s) | Publication date |
|---|---|---|---|
| US 11418199 B1 | 16-08-2022 | CN 115378429 A | 22-11-2022 |
| | | DE 102022112222 A1 | 24-11-2022 |
| | | US 11418199 B1 | 16-08-2022 |
| US 2010244971 A1 | 30-09-2010 | CN 102369671 A | 07-03-2012 |
| | | CN 105867102 A | 17-08-2016 |
| | | EP 2415172 A2 | 08-02-2012 |
| | | EP 3321750 A1 | 16-05-2018 |
| | | JP 5917734 B2 | 18-05-2016 |
| | | JP 6293801 B2 | 14-03-2018 |
| | | JP 2012522466 A | 20-09-2012 |
| | | JP 2014099898 A | 29-05-2014 |
| | | JP 2015133711 A | 23-07-2015 |
| | | JP 2016129369 A | 14-07-2016 |
| | | KR 20120003928 A | 11-01-2012 |
| | | TW 201044793 A | 16-12-2010 |
| | | US 2010244971 A1 | 30-09-2010 |
| | | US 2012081185 A1 | 05-04-2012 |
| | | WO 2010117739 A2 | 14-10-2010 |

EPO FORM P0459

For more details about this annex : see Official Journal of the European Patent Office, No. 12/82